(19) Europäisches Patentamt
European Patent Office
Office européen des brevets

(11) **EP 3 521 395 A1**

(12) **EUROPEAN PATENT APPLICATION**

(43) Date of publication:
07.08.2019 Bulletin 2019/32

(51) Int Cl.:
*C09J 7/40* (2018.01)

(21) Application number: 18198699.3

(22) Date of filing: 04.10.2018

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: 06.10.2017 JP 2017196425

(71) Applicant: **Nitto Denko Corporation**
**Ibaraki-shi, Osaka 567-8680 (JP)**

(72) Inventors:
• JOZUKA, Kenta
Ibaraki-shi, Osaka 567-8680 (JP)
• HIGUCHI, Naoaki
Ibaraki-shi, Osaka 567-8680 (JP)
• KATO, Naohiro
Ibaraki-shi, Osaka 567-8680 (JP)
• BUZOJIMA, Yasushi
Ibaraki-shi, Osaka 567-8680 (JP)

(74) Representative: **Müller-Boré & Partner**
**Patentanwälte PartG mbB**
**Friedenheimer Brücke 21**
**80639 München (DE)**

(54) **PRESSURE-SENSITIVE ADHESIVE SHEET HAVING FIRST AND SECOND RELEASE FILMS HAVING DIFFERENT ELASTIC MUDULI**

(57)     This invention provides a double-linered PSA sheet having an adhesively double-faced PSA sheet, and first and second release films placed on first and second adhesive faces of the PSA sheet. The first and second release films have tensile elastic moduli $E_1$ and $E_2$ at an $E_2/E_1$ ratio value of 1.5 or greater.
    In a preferred embodiment the first release film is a releasable polyolefin film, and the second release film is a releasable polyester film or a releasable polyolefin resin film.

[Fig. 1]

## Description

The present application claims priority to Japanese Patent Application No. 2017-196425 filed on October 6, 2017; the entire content thereof is incorporated herein by reference.

The present invention relates to a double-linered pressure-sensitive adhesive sheet (a pressure-sensitive adhesive sheet with release films).

In general, pressure-sensitive adhesive (PSA) exists as a soft solid (a viscoelastic material) in a room temperature range and has a property to adhere easily to adherend with some pressure applied. Because of such properties, in various industrial fields such as home appliance, automobiles and OA equipment, PSA has been widely used as, for instance, an on-substrate PSA sheet having a PSA layer on a support substrate or a substrate-free PSA sheet with no support substrate. Lately, the importance of PSA sheets has grown for use in bonding, fixing and protecting parts in smartphones and other mobile electronics, etc. Technical documents related to double-faced PSA tape used in fixing parts of mobile electronics include Japanese Patent Application Publication No. 2017-132911, Japanese Patent Application Publication No. 2013-100485, Japanese Patent Application Publication No. 2017-002292 and Japanese Patent Application Publication No. 2015-147873..

When fixing parts with PSA sheets in mobile electronics, bonding areas are usually small due to limiting factors such as size and weight. PSA sheets used for this purpose need to have adhesive strength capable of achieving good fastening even onto small areas, calling for higher levels of properties that are necessary to meet demand for weight reduction and downsizing. In order to increase productivity of manufacturing products such as electronics and reducing the production cost, the takt time (work time) is the first thing to look at. The PSA sheet to be used is required to provide easy bonding under light pressure as well as expected performance in a shorter curing time. For this, it needs to show good adhesive strength immediately after its application.

It may be advantageous to have a highly smooth adhesive face (PSA layer surface) in a PSA sheet from the standpoint of obtaining good performance even in a small area and reducing takt time required for its application. This is because, with the highly smooth adhesive face, a good bonding state is quickly achieved between the adhesive face and adherend surface, leading to a tendency for greater initial adhesion. In an unused PSA sheet, the surface structure of an adhesive face may reflect the surface structure of a release liner protecting the adhesive face. Thus, it is preferable to use a highly smooth release liner. As compared to a release liner with a paper substrate, a release liner (or a release film, hereinafter) with a resin film substrate generally has a highly smooth surface and is suited for making a smoother adhesive face.

However, with respect to a double-linered PSA sheet in which an adhesively double-faced PSA sheet is protected (covered) on each face with a release film, when removing one release film (first release film) covering one face of the PSA sheet, so-called "naki-wakare" (undesired lifting) is likely to occur, with the other face of the PSA sheet lifting off the other release film (second release film) covering the other face and, further, part of the PSA sheet getting cut off from the rest of the PSA sheet. Such undesired lifting may cause lowering of ease of handling and working with the PSA sheet as well as a decrease in yield. To prevent undesired lifting, it is effective to make the ease of release of the second release film sufficiently low (increase its peel strength) as compared to the ease of release of the first release film. Upon removal of the first release film, however, lower ease of release (hindered release) of the second release film tends to lower the ease of transferring the PSA sheet on the second release film to an adherend. In addition, some PSA sheets are used in an embodiment where, before application to final adherends, they are transferred to different release liners (or process liners, hereinafter), for instance, for their further processing. In other words, the adherend of the PSA sheet can be a releasable adherend such as a process liner. In such a case, to transfer the PSA sheet on the second release film to a releasable adherend, the releasable adherend needs to have lower ease of release than the second release film. There will be further obstacles in transferring the PSA sheet on such a releasable adherend to a final adherend or to the next process liner.

The present invention has been made in view of such circumstances with an objective to provide a double-linered PSA sheet less susceptible to undesired lifting.

The present description provides a double-linered PSA sheet (a PSA sheet with release films), comprising an adhesively double-faced PSA sheet, a first release film placed on the first adhesive face of the PSA sheet and a second release film placed on the second adhesive face of the PSA sheet. The first and second release films have tensile elastic moduli $E_1$ and $E_2$, respectively, at an $E_2//E_1$ ratio value of 1.5 or higher. Like this, the use of the first release film having lower rigidity than the second release film tends to reduce the occurrence of undesired lifting during removal of the first release film from the first adhesive face. This can further reduce the difference in peel strength between the first and second release films while preventing undesired lifting. As a result, it becomes possible to use a second release film with higher ease of release and the PSA sheet can be more easily transferred from the second release film to an adherend or to a process liner.

The double-linered PSA sheet according to some embodiments may have a peel strength difference ($R_2 - R_1$) of 0.2 N/50mm or less, defined as a value obtained by subtracting the first release film's peel strength $R_1$ from the second

release film's peel strength $R_2$. According to the art disclosed herein, even when the difference in peel strength is so small, undesired lifting can be favorably reduced.

The first release film preferably has a maximum test strength of 5 N or greater in a tensile test. Such a first release film can be advantageous from the standpoint of the handling properties and size stability of the first release film.

The second release film preferably has a maximum test strength of 30 N or greater in the tensile test. The double-linered PSA sheet having such a second release film can be advantageous from the standpoint of the ease of manipulating the first release film during its removal.

In some embodiments, as the first release film, a releasable polyolefin film can be preferably used. With the use of the releasable polyolefin film as the first release film, the double-linered PSA sheet can be favorably made to satisfy the $E_2/E_1$ ratio.

In some embodiments, as the second release film, a releasable polyester film can be preferably used. With the use of the releasable polyester film as the second release film, the double-linered PSA sheet can be favorably made to satisfy the $E_2/E_1$ ratio.

In some embodiments, the PSA layer forming the PSA sheet may have a storage modulus G' of 0.6 MPa or less at 25 °C. For the double-linered PSA sheet having such a PSA layer, it is particularly significant to apply the art disclosed herein to prevent undesired lifting.

In some embodiments, the PSA sheet is a substrate-free PSA sheet consisting of a PSA layer. The PSA sheet in such an embodiment is generally highly deformable and thus is more likely to tightly adhere to an adherend surface; however, it tends to be more likely to cause undesired lifting as compared to a substrate-supported PSA sheet. Accordingly, it is greatly significant to apply the art disclosed herein to reduce undesired lifting.

Fig. 1 shows a cross-sectional diagram schematically illustrating the double-linered PSA sheet according to an embodiment.

Fig. 2 shows a cross-sectional diagram schematically illustrating the double-linered PSA sheet according to another embodiment,

Preferred embodiments of the present invention are described below. Matters necessary to practice this invention other than those specifically referred to in this description can be understood by a person skilled in the art based on the disclosure about implementing the invention in this description and common general knowledge at the time of application. The present invention can be practiced based on the contents disclosed in this description and common technical knowledge in the subject field. In the drawings referenced below, a common reference numeral may be assigned to members or sites producing the same effects, and duplicated descriptions are sometimes omitted or simplified. The embodiments described in the drawings are schematized for clear illustration of the present invention, and do not necessarily represent accurate sizes or reduction scales of the PSA sheet of this invention that is actually provided as a product.

As used herein, the term "PSA" refers to, as described earlier, a material that exists as a soft solid (a viscoelastic material) in a room temperature range and has a property to adhere easily to adherend with some pressure applied. As defined in "Adhesion: Fundamental and Practice" by C. A. Dahlquist (McLaren & Sons (1966), P. 143), PSA referred to herein can be a material that has a property satisfying complex tensile modulus $E^*$ (1 Hz) $< 10^7$ dyne/cm$^2$ (typically, a material that exhibits the described characteristics at 25 °C).

As used herein, the term "(meth)acryloyl" comprehensively refers to acryloyl and methacryloyl. Similarly, the term "(meth)acrylate" comprehensively refers to acrylate and methacrylate, and the term "(meth)acryl" comprehensively refers to acryl and methacryl.

As used herein, the term "acrylic polymer" refers to a polymer comprising, as a monomeric unit constituting the polymer, a monomeric unit derived from a monomer having at least one (meth)acryloyl group per molecule. Hereinafter, a monomer having at least one (meth)acryloyl group per molecule is referred to as "acrylic monomer" as well. As used herein, the acrylic polymer is defined as a polymer comprising a monomeric unit derived from an acrylic monomer.

<Double-linered PSA sheet>

The double-linered PSA sheet disclosed herein comprises s PSA sheet having first and second adhesive faces (the sheet meaning to include a long form such as a tape form), a first release film placed on the first adhesive face of the PSA sheet, and a second release film placed on the second adhesive face of the PSA sheet.

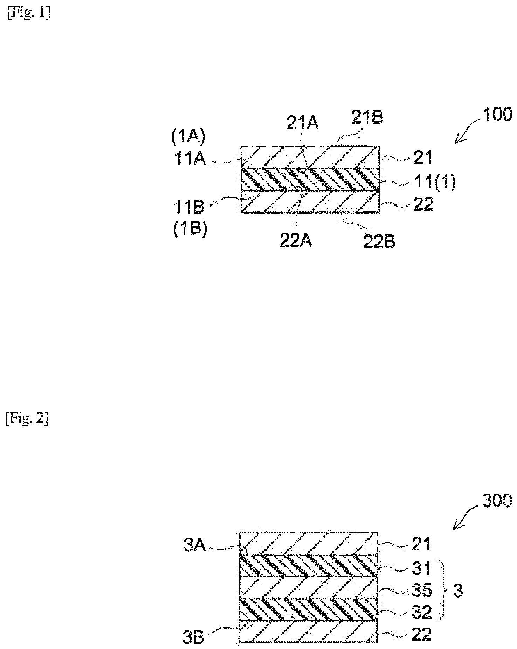

Fig. 1 shows the constitution of the double-linered PSA sheet according to an embodiment. The double-linered PSA sheet 100 comprises a substrate-free PSA sheet 1 formed of a PSA layer 11. One surface of PSA sheet 1 is the first adhesive face 1A fonned of one surface 11A of PSA layer 11; the other surface of PSA sheet 1 is the second adhesive face 1B formed of the other surface 11B of PSA layer 11. PSA layer 11 may have a monolayer structure or a multilayer structure with two or more layers. The features (materials, thicknesses, etc.) of PSA layers forming the multi-layer structure can be the same or different. From the standpoint of the productivity of manufacturing and stable properties, an embodiment where PSA layer 11 has a monolayer structure can be preferably employed.

Here, the substrate-free double-faced PSA sheet refers to a double-faced PSA sheet that includes no non-releasable support substrate between the first and second adhesive faces. The non-releasable support substrate refers to a support substrate that is not to be separated from the PSA layer while the PSA sheet including the support substrate is in use.

The first adhesive face 1A of PSA sheet 1 is protected with the first release film 21 placed on the first adhesive face 1A. The second adhesive face 1B of PSA sheet 1 is protected with the second release film 22 placed on the second adhesive face 1B. The first and second release films 21 and 22 are selected so that the $E_2/E_1$ ratio (the ratio of the tensile elastic modulus $E_1$ of the first release film 21 to the tensile elastic modulus $E_2$ of the second release film 22) has a value of 1.5 or greater.

The surface (first release face) 21A of the first release film 21 in contact with the first adhesive face 11A and the surface (second release face) 22A of the second release film 22 in contact with the second adhesive face 11B are both release faces. In other words, the PSA layer can be released from these surfaces. The first and second release faces 21A and 22A are designed to have peel strength $R_1$ and $R_2$, respectively, at a peel strength difference ($R_2 - R_1$) of 0.2 N/50mm or less. The surface 21B on the reverse side of the first release face 21A of the first release film 21 can be a release face or a non-releasable face. Similarly, the surface 22B on the reverse side of the second release face 22A of the second release film 22 can be a release face or a non-releasable face.

The double-linered PSA sheet 100 in such an embodiment can be favorably used in an embodiment where the first release film 21 is first removed from the first adhesive face 1A, the exposed first adhesive face 1A is press-bonded to the first adherend, the second release film 22 is removed from the second adhesive face 1B, and the exposed second adhesive face 1B is press-bonded to the second adherend. The adherends can be adherends to which the PSA sheet 1 is eventually applied or release faces of process liners. The process liners may be used for subjecting the PSA sheet 1 to various kinds of process or treatment or for carrying the PSA sheet 1 before the PSA sheet 1 is applied to a final adherend. Examples of the process or treatment include a process of punching or cutting to make the shape of the PSA sheet adaptable to the shape of the final adherend, treatment to prepare the PSA sheet suited for more efficient or precise application to the adherend.

Fig. 2 shows the constitution of the double-linered PSA sheet according to another embodiment. The double-linered PSA sheet 300 has a substrate-supported PSA sheet 3 that comprises a non-releasable support substrate 35, a first adhesive layer 31 covering a first surface of support substrate 35 and a second adhesive layer 32 covering a second surface of support substrate 35. The first surface of PSA sheet 3 is the first adhesive face 3A formed by one surface of the first PSA layer 31. The second surface of PSA sheet 3 is the second adhesive face 3B formed by one surface of the second PSA layer 32. The first and second PSA layers 31 and 32 may individually have a monolayer structure or a multilayer structure with two or more layers. The features (materials, thicknesses, etc.) of PSA layers forming the multi-layer structure can be the same or different. From the standpoint of the productivity of manufacturing and stable properties, an embodiment where both the first and second PSA layers 31 and 32 have monolayer structures can be preferably employed.

The first adhesive face 3A of PSA sheet 3 is protected with the first release film 21 placed on the first adhesive face 3A. The second adhesive face 3B of PSA sheet 3 is protected with the second release film 22 placed on the second adhesive face 3B. As the first and second release films 21 and 22 forming the double-linered PSA sheet 300, the same kinds can be used as for the first and second release films 21 and 22 of the double-linered PSA sheet 100 shown in Fig. 1. Similar to the double-linered PSA sheet 100, the double-linered PSA sheet 300 in such an embodiment can be favorably used in an embodiment where the first release film 21 is first removed from the first adhesive face 3A, the exposed first adhesive face 3A is press-bonded to the first adherend, the second release film 22 is removed from the second adhesive face 3B, and the exposed second adhesive face 3B is press-bonded to the second adherend.

<Release film>

The first and second release films can be selected to reduce undesired lifting, among various release liners whose substrates (release film substrates) are resin films. From the standpoint of the surface smoothness, as the release film substrate, it is typically preferable to use a resin film that has a non-porous structure and is essentially free of pores (void-free). The resin film may have a monolayer structure or a multilayer structure with two or more layers (e.g. a three-layer structure).

As the resin material forming the release film substrate, it is possible to use polyester resin, polyolefin resins, polyamide resin (PA), polyimide resin (PI), polyamide-imide resin (PAI), polyether ether ketone resin (PEEK), polyethersulfone resin (PES), polyphenylene sulfide resin (PPS), polycarbonate resin (PC), polyurethane resin (PU), ethylene-vinyl acetate resin (EVA), fluororesins such as polytetrafluoroethylene (PTFE), acrylic resin, and the like. Here, the polyester resin refers to a resin with more than 50 % (by weight) polyester. Similarly, the polyolefin resin refers to a resin with more than 50 % (by weight) polyolefin. The same applies to other resins as well.

The release film substrate may be formed, using a resinous material that comprises solely one species of resin among these resins or a resinous material in which two or more species are blended. The resin film can be a non-stretched kind or a stretched kind (e.g. uniaxially stretched or biaxially stretched).

As the polyester resin, a polyester resin that comprises, as the primary component, a polyester obtainable by polycondensation of a dicarboxylic acid and a diol is used.

Examples of the dicarboxylic acid forming the polyester include aromatic dicarboxylic acids such as phthalic acid, isophthalic acid, terephthalic acid, 2-methylterephthalic acid, 5-sulfoisophthalic acid, 4,4'-diphenyldicarboxylic acid, 4,4'-diphenyl ether dicarboxylic acid, 4,4'-diphenyl ketone dicarboxylic acid, 4,4'-diphenoxyethane dicarboxylic acid, 4,4'-diphenylsulfone dicarboxylic acid, 1,4-naphthalene dicarboxylic acid, 1,5-naphthalene dicarboxylic acid, 2,6-naphthalene dicarboxylic acid and 2,7-naphthalene dicarboxylic acid; alicyclic dicarboxylic acids such as 1,2-cyclohexane dicarboxylic acid, 1,3-cyclohexane dicarboxylic acid, and 1,4-cyclohexane dicarboxylic acid; aliphatic dicarboxylic acids such as malonic acid, succinic acid, glutaric acid, adipic acid, pimelic acid, suberic acid, azelaic acid, sebacic acid, and dodecanoic acid; unsaturated dicarboxylic acids such as maleic acid, anhydrous maleic acid, and fumaric acid; and derivatives of these (e.g. lower alcohol esters of the dicarboxylic acids such as terephthalic acid, etc.). These can be used singly as one species or in a combination of two or more species. As the polyester resin used for the second release film, an aromatic dicarboxylic acid is preferable because, in relation to the first release film, it is likely to bring about a favorable elastic modulus ratio ($E_2/E_1$) disclosed herein, etc. Particularly preferable dicarboxylic acids include terephthalic acid and 2,6-naphthalene dicarboxylic acid. For instance, it is preferable that terephthalic acid, 2,6-naphthalene dicarboxylic acid, or a combination of these accounts for 50 % by weight or more (e.g. 80 % by weight or more, typically 95 % by weight or more) of the dicarboxylic acid forming the polyester. The dicarboxylic acid may consist essentially of terephthalic acid, essentially of 2,6-naphthalene dicarboxylic acid, or essentially of terephthalic acid and 2,6-napthalene dicarboxylic acid.

Examples of the diol forming the polyester include aliphatic diols such as ethylene glycol, diethylene glycol, polyethylene glycol, propylene glycol, polypropylene glycol, 1,3-propanediol, 1,5-pentanediol, neopentyl glycol, 1,4-butanediol, 1,6-hexanediol, 1,8-octanediol, and polyoxytetramethylene glycol; alicyclic diols such as 1,2-cyclohexanediol, 1,4-cyclohexanediol, 1,1-cyclohexanedimethylol, and 1,4-cyclohexanedimethylol; and aromatic diols such as xylylene glycol, 4,4'-dihydroxybiphenyl, 2,2-bis(4'-hydroxyphenyl)propane, and bis(4-hydroxyphenyl)sulfone. These can be used singly as one species or in a combination of two or more species. From the standpoint of the transparency, etc., aliphatic diols are preferable and ethylene glycol is particularly preferable. The ratio of the aliphatic diol (preferably ethylene glycol) in the diol forming the polyester is preferably 50 % by weight or higher (e.g. 80 % by weight or higher, typically 95 % by weight or higher). The diol may essentially consist of ethylene glycol.

Examples of polyester resin films include polyethylene terephthalate (PET) films, polybutylene terephthalate (PBT) films, polyethylene naphthalate (PEN) films, and polybutylene naphthalate films.

As the polyolefin resin, solely one species of polyolefin or a combination of two or more species of polyolefin can be used. Examples of the polyolefin include an $\alpha$-olefin homopolymer, a copolymer of two or more species of $\alpha$-olefin, and a copolymer of one, two or more species of $\alpha$-olefin and another vinyl monomer. Specific examples include polyethylene (PE), polypropylene (PP), ethylene-propylene copolymers such as ethylene-propylene rubber (EPR), ethylene-propylene-butene copolymers, ethylene-butene copolymers, and ethylene-ethyl acrylate copolymers. Either a low-density (LD) polyolefin or a high-density (HD) polyolefin can be used. Examples of the polyolefin resin include non-stretched polypropylene (CPP) film, biaxially-stretched polypropylene (OPP) film, low-density polyethylene (LDPE) film, linear low-density polyethylene (LLDPE) film, medium-density polyethylene (MDPE) film, high-density polyethylene (HDPE) film, polyethylene (PE) film in which two or more species of polyethylene (PE) is blended, PP/PE blend film in which polypropylene (PP) and polyethylene (PE) are blended.

As the first release film, for instance, a releasable polyolefin resin film can be preferably used. As used herein, the releasable resin film refers to a resin film having a releasable surface at least on the PSA layer side. As the polyolefin resin film, it is possible to use polyethylenic resin films such as LDPE film, LLDPE film, and LDPE/LLDPE blend film; polypropylene resin films such as CPP film and OPP film; PP/PE blend film; and the like, but it is not limited to these. In some embodiments, as the first release film, it is preferable to use a releasable polyolefin resin film having a release layer at least on the PSA layer side surface of polyethylene resin film such as LDPE film, LLDPE film, and LDPE/LLDPE blend film.

As the second release film, for instance, a releasable polyester resin film can be preferably used. As the polyester resin film, PET film, PBT film, PEN film and the like can be used, but it is not limited to these. In some embodiments, as the second release film, it is preferable to use a releasable polyester resin film having a release layer at least on the PSA layer side surface of PET film or PBT film. Alternatively, a releasable polyolefin resin film can also be used as the second release film. For instance, as the second release film, it is possible to use a releasable polyolefin resin film having a release layer at least on the PSA layer side surface of a polyolefin resin film such as CPP film and OPP film.

While no particular limitations are imposed, examples of a combination of the first and second release films include a combination of a releasable polyethylene resin film (e.g. releasable LDPE film) as the first release film and a releasable polyester resin film (e.g. releasable PET film) as the second release film; and a combination of a releasable polyethylene resin film (e.g. releasable LDPE film) as the first release film and a releasable polypropylene resin film (e.g. releasable OPP film or releasable CPP film) as the second release film.

As long as the effect of this invention is not significantly impaired, the release film substrate may comprise, as necessary, known additives such as photostabilizer, antioxidant, anti-static agent, colorant (dye, pigment, etc.), filler, slip agent, and anti-blocking agent. The amount of an additive added is not particularly limited and can be suitably selected in accordance with the application of the double-linered PSA sheet, etc.

In some embodiments, one or each of the first and second release films can include a colorant. The colorant in at least one of the release films can facilitate distinction between the first and second release films. For instance, while the first release film includes a colorant, a transparent second release film is used to allow quick and easy identification of the first release film between the two. This can increase the yield by reducing takt time and preventing work errors.

The colorant is not particularly limited. Heretofore known pigments and dyes can be used. Non-limiting examples of pigments include inorganic pigments such as titanium oxides (e.g. titanium dioxides such as rutile titanium dioxide, anatase titanium dioxide, etc.), zinc oxide, calcium carbonates (light calcium carbonate, heavy calcium carbonate, etc.), barium carbonate, magnesium carbonate, aluminum hydroxide, calcium hydroxide, magnesium hydroxide, zinc hydroxide, zinc carbonate, zinc sulfide, talc, kaolin, barium sulfate, silica, alumina, zirconia, magnesia, lithium fluoride, calcium fluoride, iron oxide-based, iron hydroxide-based, chromium oxide-based, spinel-type sinter-based, chromic acid-based, chrome vermilion-based, Prussian blue-based, aluminum powder-based, and bronze powder-based pigments and calcium phosphate; and organic pigments such as phthalocyanine-based, azo-based, condensed azo-based, azo lake-based, anthraquinone-based, perylene/perinone-based, indigo/thioindigo-based, isoindolinone-based, azomethineazo-based, dioxazine-based, quinacridone-based, aniline black-based, triphenylmethane-based, and carbon black-based pigments.

Examples of dyes include azo-based, anthraquinone-based, quinophthalone-based, styryl-based, diphenylmethane-based, triphenylmethane-based, oxazine-based, triazine-based, xanthan-based, methane-based, azomethine-based, acridine-based, and diazine-based dyes.

The colorant color is not particularly limited. For instance, it can be white, gray, black, red, blue, yellow, green, yellowish green, orange, purple, gold, silver, pearl color, etc. A favorable example is white color.

The method for producing the release film substrate is not particularly limited. A heretofore known general resin film molding method can be suitably employed, for instance, extrusion molding, inflation molding, T-die casting, and calender roll molding.

As the release film, it is preferable to use a film having a release layer at least on a first surface of such a release film substrate. The first surface is the surface (or the front face, hereinafter) on the side where the release film faces the PSA layer. The second surface (or the backside, hereinafter) of the release film substrate may have a release layer or may not have a release layer. The method for forming the release layer is not particularly limited. For instance, the surface of the release film substrate can be treated with a known release agent to form the release layer. Examples of the release agent include silicone-based release agent, long-chain alkyl-based release agent, fluorine-based release agent and molybdenum(IV) sulfide. In some embodiments, it is preferable to use a release film having a release layer formed with a silicone-based release agent.

(Tensile elastic modulus)

In some embodiments of the double-linered PSA sheet disclosed herein, the first and second release films can be selected so that the ratio ($E_2/E_1$) of the first release film's tensile elastic modulus $E_1$ to the second release film's tensile elastic modulus $E_2$ has a value of 1.5 or greater. Hereinafter, the $E_2/E_1$ ratio may be referred to as the "elastic modulus ratio $E_2/E_1$."

The tensile elastic modulus of a release film can be determined by linear regression of a stress-strain curve obtained by cutting out a measurement sample in a suitable size from the release film subject to measurement and subjecting it to a tensile test where the test piece is elongated in one direction at room temperature (23 °C) based on JIS K 7127. More specifically, the release film subject to measurement is cut to a 10 mm wide strip to prepare a measurement sample, the two ends of the measurement sample are clamped over 20 mm with chucks, and the tensile test is carried out at an inter-chuck distance of 60 mm at a tensile speed of 150 mm/min. The measurement sample is desirably prepared so that the length direction (MD) of the release film is in the tensile direction of the sample. This method was employed to determine the tensile elastic moduli of the respective release films used in working examples described later.

According to the art disclosed herein, by selecting the first and second release films so as to obtain an elastic modulus ratio $E_2/E_1$ of 1.5 or greater, the occurrence of undesired lifting can be effectively reduced. While no theoretical restrictions are to be desired, for instance, such effect may be obtained for the following reason: When removing the first release film from the first adhesive face, peeling (separation) is usually proceeded by turning the first release film gradually from the peel initiation edge in the direction away from the first adhesive face. During this, due to the repulsive force of the turned first release film regaining its initial shape, part of the first release film up for separation from the first adhesive face is pushed against the first adhesive face. It is presumed that the locally increased tightness of adhesion between the first release film and the first adhesive face brought about by the pushing force facilitates lifting of the PSA sheet with the first release film from the second release film and further making it more susceptible to the occurrence of undesired lifting. In general, a release film with a high tensile elastic modulus is highly rigid; and therefore, by the repulsive force, it tends to be pushed more strongly against the adhesive face. With the use of a first release film having a lower tensile elastic modulus than the second release film, the force of the first release film pushing against the adhesive face during removal can be decreased. With the use of a second release film having a higher tensile elastic modulus than the first release film, the second release film and the PSA sheet held thereon exhibit great shape stability, whereby the operation to separate the first release film from the first adhesive face can proceed smoothly. This is thought to contribute to reduction of undesired lifting.

In some embodiments, the elastic modulus ratio $E_2/E_1$ may have a value of, for instance, 1.7 or greater, or even 2.0 or greater. With increasing elastic modulus ratio $E_2/E_1$, the undesired lifting resistance tends to improve. From such a standpoint, in some embodiments, the elastic modulus ratio $E_2/E_1$ can be, for instance, 3.0 or greater, 5.0 or greater, 6.0 or greater, or even 8.0 or greater. The maximum elastic modulus ratio $E_2/E_1$ is not particularly limited. From the standpoint of the ease of producing or handling the first and/or second release films, in some embodiments, the elastic modulus ratio $E_2/E_1$ can be, for instance, 50 or less, 40 or less, 30 or less, 25 or less, 20 or less, or even 15 or less. The elastic modulus ratio $E_2/E_1$ can be adjusted through selection of the first and second release films.

The tensile elastic modulus $E_1$ of the first release film is not particularly limited. From the standpoint of the ease of handling the first release film itself (e.g. its size stability, ease of processing, etc.), the tensile elastic modulus $E_1$ is suitably 0.05 GPa or greater, 0.1 GPa or greater, or even 0.15 GPa or greater. In some embodiments, it is possible to use a first release film having a tensile elastic modulus $E_1$ of 0.3 GPa or greater, for instance, 0.5 GPa or greater. From the standpoint of making it easier to obtain a favorable elastic modulus ratio $E_2/E_1$, the tensile elastic modulus $E_1$ is usually suitably 4.0 GPa or less, or preferably 3.0 GPa or less; it can also be 2.0 GPa or less, 1.5 GPa or less, or even 1.2 GPa or less. In some embodiments, it is preferable to use a first release film having a tensile elastic modulus $E_1$ of 0.8 GPa or less, 0.6 GPa or less, or 0.4 GPa or less. The tensile elastic modulus $E_1$ can be adjusted through the material and production method of the first release film.

The tensile elastic modulus $E_2$ of the second release film is not particularly limited. The tensile elastic modulus $E_2$ of the second release film is usually suitably 0.3 GPa or greater, or preferably 0.5 GPa or greater. From the standpoint of combining ease of handling of the first release film with a favorable elastic modulus ratio $E_2/E_1$, in some embodiments, the tensile elastic modulus $E_2$ can be, for instance, 0.7 GPa or greater, 0.9 GPa or greater, 1.3 GPa or greater, 1.5 GPa or greater, or even 1.7 GPa or greater. From the standpoint of the ease of handling (e.g. the ease of winding) of the second release film, in some embodiments, the tensile elastic modulus $E_2$ can be, for instance, 10 GPa or less, preferably 6.0 GPa or less, 5.0 GPa or less, 4.0 GPa or less, or even 3.0 GPa or less. The tensile elastic modulus $E_2$ can be adjusted through the material and production method of the second release film.

In some embodiments, the first release film preferably has a maximum test strength $F_1$ of 5 N or greater in a tensile test. Such a first release film may be advantageous from the standpoint of the handling properties and size stability of the first release film. The maximum test strength $F_1$ can be, for instance, 7 N or greater, 9 N or greater, 12 N or greater, or even 15 N or greater. The upper limit of the maximum test strength $F_1$ is not particularly limited. In some embodiments, the maximum test strength $F_1$ can be, for instance, 120 N or less, 100 N or less, 80 N or less, 60 N or less, 40 N or less, or even 25 N or less.

In some embodiments, the second release film has a maximum test strength $F_2$ of 30 N or greater in a tensile test. Such a second release film may show great shape retention. Thus, it may be advantageous from the standpoint of the ease of manipulation for removing the first release film from the PSA sheet while leaving the PSA sheet on the second release film. A large maximum test strength $F_2$ is preferable from the standpoint of the ease of handling and size stability of the double-linered PSA sheet. The maximum test strength $F_2$ can be, for instance, 40 N or greater, 50 N or greater, or even 65 N or greater. The upper limit of the maximum test strength $F_2$ is not particularly limited. From the standpoint of the ease of handling (e.g. the ease of winding) of the second release film, in some embodiments, the maximum test strength $F_2$ can be, for instance, 500 N or less, 300 N or less, 200 N or less, or even 150 N or less.

The maximum test strength $F_1$ and $F_2$ can be obtained based on the results of the aforementioned tensile test. The maximum test strength $F_1$ and $F_2$ can be adjusted through the materials, production methods, thicknesses, etc., of the first and second release films.

The maximum strain point $\varepsilon_1$ of the first release film is not particularly limited. In some embodiments, the maximum strain point $\varepsilon_1$ can be, for instance, 150 % or higher, 175 % or higher, or even 200 % or higher. A first release film having a large maximum strain point $\varepsilon_1$ tends to show good flexibility. Thus, it can be preferably used as the first release film of the double-linered PSA sheet disclosed herein. From the standpoint of the handling properties of the first release film, the maximum strain point $\varepsilon_1$ is usually suitably 1000 % or lower; it can be 700 % or lower, 500 % or lower, or even 400 % or lower.

The maximum strain point $\varepsilon_2$ of the second release film is not particularly limited. In some embodiments, the maximum strain point $\varepsilon_2$ can be, for instance, 300 % or lower, 250 % or lower, or even 200 % or lower. A second release film having a small maximum strain point $\varepsilon_2$ shows great shape retention and facilitates the operation for removing the first release film while leaving the PSA sheet on the second release film. Thus, it can be preferably used as the second release film of the double-linered PSA sheet disclosed herein. The lower limit of the maximum strain point $\varepsilon_2$ is not particularly limited. From the standpoint of the ease of handling the second release film, it is usually suitably 70 % or higher; it can be 100 % or higher, or even 120 % or higher. In some embodiments, a second release film having a maximum strain point $\varepsilon_2$ of 150 % or higher or 180 % or higher can also be used.

The maximum strain points $\varepsilon_1$ and $\varepsilon_2$ can be obtained based on the results of the aforementioned tensile test. The maximum strain points $\varepsilon_1$ and $\varepsilon_2$ can be adjusted through the materials, production methods, etc., of the first and second release films.

The first and second release films can be selected so that the ratio ($\varepsilon_1/\varepsilon_2$) of the first release film's maximum strain point $\varepsilon_1$ to the second release film's maximum strain point $\varepsilon_2$ has a value of 1.2 or greater. According to a combination of such first and second release films, the occurrence of undesired lifting tends to be better prevented. In some embodiments, the $\varepsilon_1/\varepsilon_2$ ratio value can be, for instance, 1.4 or greater, or even 1.5 or greater. The maximum $\varepsilon_1/\varepsilon_2$ ratio value is not particularly limited. It can be, for instance, 7.0 or less, or even 5.0 or less.

(Peel strength)

In the double-linered PSA sheet disclosed herein, there are no particular limitations to the peel strength difference ($R_2 - R_1$) defined as the value obtained by subtracting the peel strength $R_1$ of the first release film from the peel strength $R_2$ of the second release film. The peel strength difference ($R_2 - R_1$) can be selected in accordance with the purpose and way of use as long as undesired lifting of the PSA sheet can be adequately prevented. The peel strength difference ($R_2 - R_1$) can be, for instance, 1.0 N/50mm or less, 0.8 N/50mm or less, 0.5 N/50mm or less, or even 0.3 N/50mm or less. The peel strength difference ($R_2 - R_1$) can be, for instance, 1.00 N/50mm or less, 0.80 N/50mm or less, 0.50 N/50mm or less, 0.30 N/50mm or less, 0.20 N/50mm or less, or even 0.10 N/50mm or less.

In the double-linered PSA sheet according to some preferable embodiments, the peel strength difference ($R_2 - R_1$) can be, for instance, 0.25 N/50mm or less, 0.2 N/50mm or less, 0.15 N/50mm or less, 0.1 N/50mm or less, 0.07 N/50mm or less, or even 0.05 N/50mm or less. According to the double-linered PSA sheet having such a small peel strength difference ($R_2 - R_1$), the peel strength of the second release film can be lowered. A decrease in peel strength of the second release film makes it easier to transfer the PSA sheet to an adherend by applying the first adhesive face of the PSA sheet held on the second release film to the adherend surface (possibly a releasable surface of a process liner, etc., a low adhesive or hard-to-stick-to surface of a low polar material, etc.). In particular, in the double-linered PSA sheet used in an embodiment that includes applying the first adhesive face to a process liner to transfer the PSA sheet to the process liner, by lowering the peel strength of the second release film, even if the peel strength of the process liner is further lowered, the PSA sheet can be transferred to the process liner. The allowed use of a process liner with lower peel strength is advantageous from the standpoint of the ease of transferring the PSA sheet on the process liner to an adherend surface (possibly the surface of a subsequent process liner or the surface of a hard-to-stick-to material).

The peel strength $R_1$ of the first release film is not particularly limited. From the standpoint of making it easier to obtain higher ease of transfer to adherends by reducing the peel strength $R_2$ of the second release film, the first release film's peel strength $R_1$ is usually suitably 3.0 N/50mm or less, preferably 2.0 N/50mm or less, or more preferably 1.5 N/50mm or less. In some embodiments, the first release film's peel strength $R_1$ can be, for instance, 1.0 N/50mm or less, 0.7 N/50mm or less, 0.5 N/50mm or less, 0.3 N/50mm or less, or even 0.2 N/50mm or less. The first release film's peel strength $R_1$ can be, for instance, 3.00 N/50mm or less, 2.00 N/50mm or less, 1.50 N/50mm or less, 1.00 N/50mm or less, 0.70 N/50mm or less, 0.50 N/50mm or less, 0.30 N/50mm or less, or even 0.20 N/50mm or less. The minimum first release film's peel strength $R_1$ is not particularly limited. From the standpoint of favorably protecting the first adhesive face, it is usually suitably 0.01 N/50mm or greater. In some embodiments, the peel strength $R_1$ can be, for instance, 0.05 N/50mm or greater, 0.08 N/50mm or greater, or even 0.1 N/50mm or greater. The peel strength $R_1$ can also be 0.10 N/50mm or greater.

The peel strength $R_2$ of the second release film is not particularly limited. From the standpoint of obtaining higher ease of transfer of the PSA sheet held on the second release film to adherends, the second release film's peel strength $R_2$ is usually suitably 5.0 N/50mm or less, preferably 3.0 N/50mm or less, or more preferably 2.0 N/50mm or less. In some embodiments, the second release film's peel strength $R_2$ can be, for instance, 1.5 N/50mm or less, 1.0 N/50mm or less, 0.6 N/50mm or less, 0.4 N/50mm or less, or 0.3 N/50mm or less. The second release film's peel strength $R_2$ can be, for instance, 5.00 N/50mm or less, 3.00 N/50mm or less, 2.00 N/50mm or less, 1.50 N/50mm or less, 1.00 N/50mm or less, 0.60 N/50mm or less, 0.40 N/50mm or less, or even 0.30 N/50mm or less. The minimum second release film's peel strength $R_2$ is not particularly limited. From the standpoint of favorably protecting the second adhesive face, it is usually suitably 0.01 N/50mm or greater. In some embodiments, the peel strength $R_2$ can be, for instance, 0.05 N/50mm or greater, 0.08 N/50mm or greater, 0.10 N/50mm or greater, or even 0.12 N/50mm or greater.

The value of the peel strength difference ($R_2$ - $R_1$) is not limited to a positive number. The value of the peel strength difference ($R_2$ - $R_1$) can be 0 N/50mm or less, or below 0 N/50mm as long as undesired lifting can be prevented or reduced when removing the first release film from the first adhesive face of the PSA sheet while leaving the PSA sheet on the second release film.

The peel strength (N/50mm) is determined by the following method: In an environment at 23 °C and 50 % RH, to the release face of a release film subject to measurement, a single-faced PSA tape (single-faced PSA tape having an acrylic PSA layer on a polyester substrate, product name No. 31B, substrate thickness 25 $\mu$m, overall thickness 53 $\mu$m, 19 mm wide) available from Nitto Denko Corporation is applied and placed under a 5 kg load for 24 hours. Subsequently, using a universal tensile tester, peeling is carried out at a tensile speed of 0.3 m/min at a peel angle of 180°. The peel strength (N/19mm) observed during this is converted to the value per 50 mm width to determine the peel strength (N/50mm). This method was employed to determine the peel strength of the respective release films and the release film for testing ease of transfer used in the working examples described later. The peel strength can be adjusted through the materials and thicknesses of the release film substrates, the type of release agent used for release layer formation, the thicknesses of the release layers and the conditions of their formation, etc.

The thicknesses of the release films are not particularly limited. For the balance between strength and flexibility, it is usually preferable to use release films having thicknesses of about 10 $\mu$m to about 500 $\mu$m.

In some embodiment, the first release film may have a thickness $t_1$ of, for instance, 20 $\mu$m or greater, 30 $\mu$m or greater, or even 45 $\mu$m or greater. An increase in thickness $t_1$ of the first release film tends to increase the ease of handling. From the standpoint of avoiding an unnecessarily large thickness of the double-linered PSA sheet, the thickness $t_1$ of the first release film can be, for instance, 250 $\mu$m or less, 150 $\mu$m or less, or even 100 $\mu$m or less.

In some embodiment, the second release film may have a thickness $t_2$ of, for instance, 10 $\mu$m or greater, 20 $\mu$m or greater, 30 $\mu$m or greater, or even 35 $\mu$m or greater. An increase in thickness $t_2$ of the second release film tends to increase the ease of handling. For instance, when the double-linered PSA sheet can be used in an embodiment where the PSA sheet on the second release film is transferred to a releasable surface (a release face of a process liner, etc.) or in an embodiment where it is applied to a hard-to-stick-to adherend, from the standpoint of facilitating the transfer, the thickness $t_2$ of the second release film can be, for instance, 150 $\mu$m or less, 100 $\mu$m or less, 80 $\mu$m or less, 60 $\mu$m or less, or even 45 $\mu$m or less. Alternatively, like, for instance, a double-linered PSA sheet that can be used in an embodiment where the first adhesive face is applied to a final adherend with high precision, when the double-linered PSA sheet is used for applications where importance is placed on the shape retention and size stability of the PSA sheet held on the second release film, the thickness $t_2$ of the second release film can be, for instance, 70 $\mu$m or greater, 120 $\mu$m or greater, or even 160 $\mu$m or greater.

The relation between the thicknesses $t_1$ and $t_2$ of the first and second release films is not particularly limited. The ratio of the first release film's thickness $t_1$ to the second release film's thickness $t_2$, that is, the thickness ratio ($t_1/t_2$), can be, for instance, about 0.3 to 10. When the double-linered PSA sheet can be used in an embodiment where the PSA sheet on the second release film is transferred to a releasable surface or in an embodiment where it is applied to a hard-to-stick-to adherend, the thickness ratio ($t_1/t_2$) can be, for instance, about 1 to 10; it is usually suitably higher than 1 and 5 or lower, or possibly higher than 1 and 3 or lower. When the double-linered PSA sheet is used for applications where importance is placed on the shape retention and size stability of the PSA sheet held on the second release film, the thickness ratio ($t_1/t_2$) can be, for instance, about 0.3 to 3, or even about 0.5 to 2.

<PSA layer>

In the art disclosed herein, the type of PSA that constitutes the PSA layer is not particularly limited. For example, the PSA layer may be constituted, comprising one, two or more species of PSA selected among various known species of PSA, such as an acrylic PSA, rubber-based PSA (natural rubber-based, synthetic rubber-based, their mixture-based, etc.), silicone-based PSA, polyester-based PSA, urethane-based PSA, polyether-based PSA, polyamide-based PSA, fluorine-based PSA, etc. Herein, the acrylic PSA refers to a PSA comprising a (meth)acrylic polymer as the base polymer (the primary component among polymers, i.e. a component accounting for more than 50 % by weight). The same applies to the rubber-based PSA and other PSA.

In a PSA layer preferable from the standpoint of the transparency, weatherability, etc., the acrylic PSA content is 50 % by weight or greater, more preferably 70 % by weight or greater, or yet more preferably 90 % by weight or greater. The acrylic PSA content can be greater than 98 % by weight, or the PSA layer may be formed essentially of an acrylic PSA.

(Acrylic polymer)

While no particular limitations are imposed, in a preferable embodiment of the art disclosed herein, the PSA forming the PSA layer and the PSA composition for forming the PSA comprise an acrylic polymer as the base polymer. The acrylic polymer is preferably a polymer of a starting monomer mixture that comprises an alkyl (meth)acrylate as the primary monomer and may further comprise a copolymerizable secondary monomer. Here, the primary monomer refers to a component that accounts for more than 50 % by weight of the starting monomers.

As the alkyl (meth)acrylate, for instance, a compound represented by the formula (1) below can be favorably used.

$$CH_2=C(R^1)COOR^2 \qquad (1)$$

Here, $R^1$ in the formula (1) is a hydrogen atom or a methyl group. $R^2$ is an acyclic alkyl group having 1 to 20 carbon atoms (hereinafter, such a range of the number of carbon atoms may be indicated as "$C_{1-20}$"). From the standpoint of the PSA's storage modulus, etc., an alkyl (meth)acrylate wherein $R^2$ is a $C_{1-14}$ acyclic alkyl group is preferable, and an alkyl (meth)acrylate wherein $R_2$ is a $C_{1-10}$ acyclic alkyl group is more preferable. An alkyl (meth)acrylate wherein $R^2$ is a butyl group or a 2-ethylhexyl group is particularly preferable.

Examples of an alkyl (meth)acrylate with $R^2$ being a $C_{1-20}$ acyclic alkyl group include methyl (meth)acrylate, ethyl (meth)acrylate, propyl (meth)acrylate, isopropyl (meth)acrylate, n-butyl (meth)acrylate, isobutyl (meth)acrylate, s-butyl (meth)acrylate, pentyl (meth)acrylate, isopentyl (meth)acrylate, hexyl (meth)acrylate, heptyl (meth)acrylate, 2-ethylhexyl (meth)acrylate, n-octyl (meth)acrylate, isooctyl (meth)acrylate, n-nonyl (meth)acrylate, isononyl (meth)acrylate, n-decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, eicosyl (meth)acrylate, etc. These alkyl (meth)acrylates can be used solely as one species or in a combination of two or more species. Particularly preferable (meth)acrylates include n-butyl acrylate (BA) and 2-ethylhexyl acrylate (2EHA).

The art disclosed herein can be preferably implemented in an embodiment where the monomers forming the acrylic polymer include at least BA or 2EHA and the combined amount of BA and 2EHA accounts for 75 % by weight or more (usually 85 % by weight or more, e.g. 90 % by weight or more, or even 95 % by weight or more) of the alkyl (meth)acrylate in the monomers. For instance, the art disclosed herein can be implemented in embodiments where the monomers consist of, as the alkyl (meth)acrylate, solely BA, solely 2EHA, both BA and 2EHA, etc.

When the monomers include both BA and 2EHA, the BA to 2EHA weight ratio (BA/2EHA) is not particularly limited. For instance, it can be 1/99 or higher and 99/1 or lower. In a preferable embodiment, BA/2EHA can be 40/60 or lower (e.g. 1/99 or higher and 40/60 or lower), 20/80 or lower, or even 10/90 or lower (e.g. 1/99 or higher and 10/90 or lower).

In a preferable embodiment of the art disclosed herein, an acidic group-containing monomer is used as a monomer that is copolymerizable with the alkyl (meth)acrylate which is the primary monomer. The acidic group-containing monomer can enhance cohesion based on its polarity and provide bonding strength relative to polar adherends. When a crosslinking agent such as isocyanate-based and epoxy-based crosslinking agents is used, the acidic group (typically a carboxyl group) serves as a crosslinking point in the acrylic polymer. These effects increase the strength of the PSA layer and the acrylic polymer can be preferably designed to be suited for reducing undesired lifting.

As the acidic group-containing monomer, a carboxy group-containing monomer is preferably used. Examples of the carboxy group-containing monomer include ethylenic unsaturated monocarboxylic acids such as acrylic acid (AA), methacrylic acid (MAA), carboxyethyl (meth)acrylate, crotonic acid, and isocrotonic acid; and ethylenic unsaturated dicarboxylic acids such as maleic acid, itaconic acid and citraconic acid as well as their anhydrides (maleic acid anhydride, itaconic acid anhydride, etc.). The acidic group-containing monomer can be a monomer having a metal carboxylate (e.g. an alkali metal salt). In particular, AA and MAA are preferable, with AA being more preferable. When one, two or more species of acidic group-containing monomers are used, the ratio of AA in the acidic group-containing monomer is preferably 50 % by weight or higher, more preferably 70 % by weight or higher, or yet more preferably 90 % by weight or higher. In a particularly preferable embodiment, the acidic group-containing monomer essentially consists of AA.

The acidic group-containing monomer content (typically the carboxy group-containing monomer content) in the monomers (i.e. the copolymerization ratio of the acidic group-containing monomer in the acrylic polymer) can be, for instance, 0.5 % by weight or higher, 1 % by weight or higher, or even 3 % by weight or higher. From the standpoint of making it easier to obtain higher cohesion, in some embodiments, the acidic group-containing monomer content can also be, for instance, 5 % by weight or higher, 8 % by weight or higher, or even 10 % by weight or higher. From the standpoint of quickly achieving good adhesion to adherends, the acidic group-containing monomer content can be, for instance, 15 % by weight or lower, 13 % by weight or lower, or even 12 % by weight or lower.

In the art disclosed herein, as the secondary monomer copolymerizable with the alkyl (meth)acrylate that is the primary monomer, a copolymerizable monomer can be used excluding carboxy group-containing monomers. As the secondary monomer, for instance, functional group-containing monomers such as those shown below can be used.

Hydroxy group-containing monomers: e.g. hydroxyalkyl (meth)acrylates such as 2-hydroxyethyl (meth)acrylate, 2-hydroxypropyl (meth)acrylate, 3-hydroxypropyl (meth)acrylate, and 4-hydroxybutyl (meth)acrylate; unsaturated alcohols such as vinyl alcohol and allyl alcohol; and poly(propylene glycol mono(meth)acrylate).

Amide group-containing monomers: for example, (meth)acrylamide, N,N-dimethyl(meth)acrylamide, N-butyl(meth)acrylamide, N-methylol(meth)acrylamide, N-methylolpropane(meth)acrylamide, N-methoxymethyl(meth)acrylamide, N-butoxymethyl(meth)acrylamide.

Amino group-containing monomers: e.g. aminoethyl (meth)acrylate, N,N-dimethylaminoethyl (meth)acrylate and t-butylaminoethyl (meth)acrylate.

Epoxy group-containing monomers: e.g. glycidyl (meth)acrylate, methylglycidyl (meth)acrylate, and allyl glycidyl ether.

Cyano group-containing monomers: e.g. acrylonitrile, methacrylonitrile.

Keto group-containing monomers: e.g. diacetone (meth)acrylamide, diacetone (meth)acrylate, vinyl methyl ketone, vinyl ethyl ketone, allyl acetoacetate, vinyl acetoacetate.

Monomers having nitrogen atom-containing rings: e.g. N-vinyl-2-pyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-vinylmorpholine, N-vinylcaprolactam, and N-(meth)acryloyl morpholine.

Alkoxysilyl group-containing monomers: e.g. (3-(meth)acryloxypropyl)trimethoxysilane, (3-(meth)acryloxypropyl)triethoxysilane, (3-(meth)acryloxypropyl)methyldimethoxysilane, (3-(meth)acryloxypropyl)methyldiethoxysilane.

For the functional group-containing monomer, solely one species or a combination of two or more species can be used. When the monomers forming the acrylic polymer include a functional group-containing monomer, the ratio of the functional group-containing monomer in the monomers is suitably selected in accordance with required properties of the PSA sheet. The ratio (copolymerization ratio) of the functional group-containing monomer is suitably about at least 0.1 % by weight (e.g. at least 0.5 % by weight, usually at least 1 % by weight) of the monomers. Its upper limit is preferably about 40 % by weight or lower (e.g. 30 % by weight or lower, usually 20 % by weight or lower). In a more preferable embodiment, the ratio of the functional group-containing monomer excluding the acidic group-containing monomer can be, for instance, 10 % by weight or lower, or yet suitably 5 % by weight or lower; it can be 1 % by weight or lower. The monomers forming the acrylic polymer can be essentially free of a functional group-containing monomer besides the acidic group-containing monomer.

As for a monomer forming the acrylic polymer, to increase the cohesion of the acrylic polymer, etc., other comonomer(s) can be used besides the aforementioned acidic group-containing monomers. Examples of such comonomers include vinyl ester-based monomers such as vinyl acetate, vinyl propionate and vinyl laurate; aromatic vinyl compounds such as styrene, substituted styrenes (α-methylstyrene, etc.), and vinyl toluene; cycloalkyl (meth)acrylates such as cyclohexyl (meth)acrylate, cyclopentyl (meth)acrylate, and isobornyl (meth)acrylate; aromatic ring-containing (meth)acrylates such as aryl (meth)acrylate (e.g. phenyl (meth)acrylate), aryloxyalkyl (meth)acrylate (e.g. phenoxyethyl (meth)acrylate), and arylalkyl (meth)acrylate (e.g. benzyl (meth)acrylate); olefinic monomers such as ethylene, propylene, isoprene, butadiene, and isobutylene; chlorine-containing monomers such as vinyl chloride and vinylidene chloride; isocyanate group-containing monomers such as 2-(meth)acryloyloxyethyl isocyanate; alkoxy group-containing monomers such as methoxyethyl (meth)acrylate, and ethoxyethyl (meth)acrylate; and vinyl ether-based monomers such as methyl vinyl ether and ethyl vinyl ether.

The amount of the other comonomer(s) can be suitably selected in accordance with the purpose and application and is not particularly limited. It is usually preferably 10 % by weight or less of the monomers. For instance, when a vinyl ester-based monomer (e.g. vinyl acetate) is used as the other comonomer(s), its amount can be, for instance, about 0.1 % by weight or more (usually about 0.5 % by weight or more) of the monomers, or suitably about 20 % by weight or less (usually about 10 % by weight or less).

The acrylic polymer may comprise a polyfunctional monomer having at least two polymerizable functional groups (typically radically-polymerizable functional groups), each having an unsaturated double bond such as a (meth)acryloyl group and a vinyl group. The use of the polyfunctional monomer as a monomer can enhance the cohesion of the PSA layer. The polyfunctional monomer can be used as a crosslinking agent.

Examples of the polyfunctional monomer include an ester of a polyol and a (meth)acrylic acid such as ethylene glycol di(meth)acrylate, propylene glycol di(meth)acrylate, (poly)ethylene glycol di(meth)acrylate, (poly)propylene glycol di(meth)acrylate, neopentyl glycol di(meth)acrylate, pentaerythritol di(meth)acrylate, pentaerythritol tri(meth)acrylate, dipentaerythritol hexa(meth)acrylate, 1,2-ethyleneglycol di(meth)acrylate, 1,4-butanediol di(meth)acrylate, 1,6-hexanediol di(meth)acrylate, 1,12-dodecanediol di(meth)acrylate, trimethylolpropane tri(meth)acrylate, tetramethylolmethane tri(meth)acrylate, etc.; allyl (meth)acrylate, vinyl (meth)acrylate, divinylbenzene, epoxy acrylate, polyester acrylate, urethane acrylate, and the like. Among them, preferable examples are trimethylolpropane tri(meth)acrylate, 1,6-hexanediol di(meth)acrylate, and dipentaerythritol hexa(meth)acrylate. A particularly preferable examples is 1,6-hexanediol di(meth)acrylate. The polyfunctional monomers can be used solely as one species or in combination of two or more species. From the standpoint of the reactivity, etc., it is usually preferable to use a polyfunctional monomer having two or more acryloyl groups.

The amount of the polyfunctional monomer used is not particularly limited. It can be set to suitably achieve the purpose of use of the polyfunctional monomer. From the standpoint of combining well-balanced initial adhesion and cohesion, the polyfunctional monomer is used in an amount of preferably about 3% by weight or less, more preferably 2% by weight or less, or even more preferably about 1 % by weight or less (e.g. about 0.5 % by weight or less) of the monomers. When using a polyfunctional monomer, its lower limit of use should just be greater than 0 % by weight and is not particularly limited. In usual, when the polyfunctional monomer used accounts for about 0.001 % by weight or greater (e.g. about 0.01 % by weight or greater) of the monomers, the effect of the use of the polyfunctional monomer can be suitably obtained.

It is suitable to design the composition of monomers forming the acrylic polymer so that the acrylic polymer has a glass transition temperature (Tg) of about -15 °C or lower (e.g. about -70 °C or higher and -15 °C or lower). Here, the acrylic polymer's Tg refers to the value determined by the Fox equation based on the composition of the monomers. As shown below, the Fox equation is a relational expression between the Tg of a copolymer and glass transition temperatures Tgi of homopolymers of the respective monomers constituting the copolymer.

$$1/Tg = \Sigma(Wi/Tgi)$$

In the Fox equation, Tg represents the glass transition temperature (unit: K) of the copolymer, Wi the weight fraction (copolymerization ratio by weight) of a monomer i in the copolymer, and Tgi the glass transition temperature (unit: K) of homopolymer of the monomer i.

As the glass transition temperatures of homopolymers used for determining the Tg value, values found in publicly known documents are used. For example, with respect to the monomers listed below, as the glass transition temperatures of homopolymers of the monomers, the following values are used:

| | |
|---|---|
| 2-ethylhexyl acrylate | -70 °C |
| n-butyl acrylate | -55 °C |
| ethyl acrylate | -22 °C |
| methyl acrylate | 8 °C |
| methyl methacrylate | 105 °C |
| 2-hydroxyethyl acrylate | -15 °C |
| 4-hydroxybutyl acrylate | -40 °C |
| vinyl acetate | 32 °C |
| styrene | 100 °C |
| acrylic acid | 106 °C |
| methacrylic acid | 228 °C |

With respect to the glass transition temperatures of homopolymers of monomers other than those listed above, values given in "Polymer Handbook" (3rd edition, John Wiley & Sons, Inc., Year 1989) are used. When the literature provides two or more values for a certain monomer, the highest value is used. For a monomer for which no glass transition temperature of its homopolymer is listed in the reference book, a value obtained by the method described in Japanese Patent Application Publication No. 2007-51271 shall be used.

While no particular limitations are imposed, from the standpoint of the adhesion, the acrylic polymer's Tg is advantageously about -25 °C or lower, preferably about -35 °C or lower, more preferably about -40 °C or lower, yet more preferably -45 °C or lower, or particularly preferably -50 °C or lower. From the standpoint of the cohesive strength of the PSA layer, the acrylic polymer's Tg is usually about -75 °C or higher, or preferably about -70 °C or higher. The art disclosed herein can be preferably implemented in an embodiment where the acrylic polymer's Tg is about -65 °C or higher and -40 °C or lower (e.g. about -65 °C or higher and about -45 °C or lower). In some embodiments, the acrylic polymer's Tg can also be about -65 °C or higher and about -55 °C or lower. The acrylic polymer's Tg can be adjusted by suitably changing the monomer composition (i.e. the monomer species used in synthesizing the polymer and their ratio).

The weight average molecular weight (Mw) of the acrylic polymer is not particularly limited. It can be, for instance, about $10 \times 10^4$ or higher and about $500 \times 10^4$ or lower. From the standpoint of the cohesion, the Mw is usually about $30 \times 10^4$ or higher, or suitably about $45 \times 10^4$ or higher (e.g. about $65 \times 10^4$ or higher). In a preferable embodiment, from the standpoint of obtaining greater tensile resistance (anti-tearing properties) of the PSA layer based on enhanced cohesion due to the high-molecular-weight polymer, the acrylic polymer's Mw can be, for instance, about $70 \times 10^4$ or higher, about $75 \times 10^4$ or higher, about $90 \times 10^4$ or higher, or even about $95 \times 10^4$ or higher. The Mw is usually suitably $300 \times 10^4$ or lower (more preferably about $200 \times 10^4$ or lower, e.g. about $150 \times 10^4$ or lower). The Mw of the acrylic polymer can also be about $140 \times 10^4$ or lower.

The Mw is determined from values based on standard polystyrene obtained by GPC (gel permeation chromatography). As the GPC system, for instance, model name HLC-8320 GPC (column: TSKgel GMH-H(S) available from Tosoh Corporation) can be used.

<PSA Composition>

The PSA layer disclosed herein can be formed with a PSA composition that comprises monomers in a composition as described above as a polymerized product, in a non-polymerized form (i.e. in a form where the polymerizable functional groups are still unreacted), or as a mixture of these. The PSA composition may be in various forms such as a solvent-based PSA composition which comprises PSA (adhesive components) in an organic solvent; an aqueous PSA composition which comprises PSA dispersed in an aqueous solvent; an active energy ray-curable PSA composition prepared so as to form PSA when cured with active energy rays such as UV rays, radioactive rays, etc.; and a hot melt-type PSA composition which is heated to melting for application and allowed to cool to around room temperature to form PSA. From the standpoint of the adhesive properties, etc., the art disclosed herein can be implemented particularly preferably in an embodiment comprising a PSA layer formed from a solvent-based PSA composition or an active energy ray-curable PSA composition.

Herein, the term "active energy ray" in this description refers to an energy ray having energy capable of causing a chemical reaction such as polymerization, crosslinking, initiator decomposition, etc. Examples of the active energy ray herein include lights such as ultraviolet (UV) rays, visible lights, infrared lights, radioactive rays such as $\alpha$ rays, $\beta$ rays, $\gamma$ rays, electron beam, neutron radiation, and X rays.

The PSA composition typically comprises at least some of the monomers (possibly a certain species among the monomers or a fraction of its quantity) as a polymer. The polymerization method for forming the polymer is not particularly limited. Heretofore known various polymerization methods can be suitably used. For instance, thermal polymerization (typically carried out in the presence of a thermal polymerization initiator) such as solution polymerization, emulsion polymerization, bulk polymerization, etc.; photopolymerization carried out by irradiating light such as UV light, etc. (typically in the presence of a photopolymerization initiator); active energy ray polymerization carried out by irradiating radioactive rays such as $\beta$ rays, $\gamma$ rays, etc.; and the like. In particular, solution polymerization and photopolymerization is preferable. In these polymerization methods, the embodiment of polymerization is not particularly limited. It can be carried out with a suitable selection of a heretofore known monomer supply method, polymerization conditions (temperature, time, pressure, irradiance of light, irradiance of radioactive rays, etc.), materials (polymerization initiator, surfactant, etc.) used besides the monomers, etc.

For instance, in a preferable embodiment, the acrylic polymer can be synthesized by solution polymerization. The solution polymerization gives a polymerization reaction mixture in a form where an acrylic polymer is dissolved in an organic solvent. The PSA layer in the art disclosed herein may be formed from a PSA composition comprising the polymerization reaction mixture or an acrylic polymer solution obtained by subjecting the reaction mixture to a suitable work-up. For the acrylic polymer solution, the polymerization reaction mixture can be used after adjusted to suitable viscosity (concentration) as necessary. Alternatively, an acrylic polymer can be synthesized by a polymerization method (e.g. emulsion polymerization, photopolymerization, bulk polymerization, etc.) other than solution polymerization and an acrylic polymer solution prepared by dissolving the acrylic polymer in an organic solvent can be used as well.

As the method for supplying monomers in solution polymerization, all-at-once supply by which all starting monomers are supplied at once, continuous supply (addition), portion-wise supply (addition) and like method can be suitably employed. The polymerization temperature can be suitably selected in accordance with the species of monomers and the solvent used, the type of polymerization initiator and the like. It can be, for instance, about 20 °C to 170 °C (usually about 40 °C to 140 °C). In a preferable embodiment, the polymerization temperature can be about 75 °C or lower (more preferably about 65 °C or lower, e.g. about 45 °C to about 65 °C).

The solvent used for solution polymerization (polymerization solvent) can be suitably selected among heretofore known organic solvents. For instance, one species of solvent or a mixture of two or more species of solvents can be used, selected among aromatic compounds (e.g. aromatic hydrocarbons) such as toluene and xylene; acetic acid esters such as ethyl acetate and butyl acetate; aliphatic or alicyclic hydrocarbons such as hexane, cyclohexane and methyl cyclohexane; halogenated alkanes such as 1,2-dichloroethane; lower alcohols (e.g. monovalent alcohols with 1 to 4 carbon atoms) such as isopropyl alcohol; ethers such as tert-butyl methyl ether; and ketones such as methyl ethyl ketone and acetone.

On the other hand, in another embodiment of the art disclosed herein, when an active energy ray-curable PSA composition (typically a photocuring PSA composition) is used, as the active energy ray-curable PSA composition, one essentially free of an organic solvent is preferable from the standpoint of the environmental health, etc. For instance, a PSA composition having about 5 % by weight or less (more preferably about 3 % by weight or less, e.g. about 0.5 % by weight or less) organic solvent content is preferable. A PSA composition essentially free of a solvent (meaning to include an organic solvent and an aqueous solvent) is preferable because it is suitable for forming a PSA layer in an embodiment where a wet layer of the PSA composition is cured between a pair of release films as described later. For instance, a preferable PSA composition has a solvent content of about 5 % by weight or less (more preferably about 3 % by weight or less, e.g. about 0.5 % by weight or less). The solvent herein refers to a volatile component that should be eliminated in the process of forming the PSA layer, that is, a volatile component that is not to be a component of the final PSA layer formed.

For the polymerization, depending on the polymerization method and embodiment of polymerization, etc., known or commonly-used thermal polymerization initiator or photopolymerization initiator can be used. These polymerization initiators can be used singly as one species or in a suitable combination of two or more species.

The thermal polymerization initiator is not particularly limited. For example, azo-based polymerization initiator, peroxide-based polymerization initiator, a redox-based polymerization initiator by combination of a peroxide and a reducing agent, substituted ethane-based polymerization initiator and the like can be used. More specific examples include, but not limited to, azo-based initiators such as 2,2'-azobisisobutyronitrile (AIBN), 2,2'-azobis(2-methylpropionamidine) disulfate, 2,2'-azobis(2-amidinopropane) dihydrochloride, 2,2'-azobis[2-(5-methyl-2-imidazolin-2-yl)propane] dihydrochloride, 2,2'-azobis(N,N'-dimethyleneisobutylamidine), and 2,2'-azobis[N-(2-carboxyethyl)-2-methylpropionamidine] hydrate; persulfates such as potassium persulfate and ammonium persulfate; peroxide-based initiators such as benzoyl peroxide (BPO), t-butyl hydroperoxide, and hydrogen peroxide; substituted ethane-based initiators such as phenyl-substituted ethane; redox-based initiators such as combination of a persulfate salt and sodium hydrogen sulfite, and combination of a peroxide and sodium ascorbate. Thermal polymerization can be preferably carried out at a temperature of, for instance, about 20 °C to 100 °C (typically 40 °C to 80 °C).

The photopolymerization initiator is not particularly limited. For instance, the following species can be used: ketal-based photopolymerization initiators, acetophenone-based photopolymerization initiators, benzoin ether-based photopolymerization initiators, acylphosphine oxide-based photopolymerization initiators, $\alpha$-ketol-based photopolymerization initiators, aromatic sulfonyl chloride-based photopolymerization initiators, photoactive oxime-based photopolymerization initiators, benzoin-based photopolymerization initiators, benzil-based photopolymerization initiators, benzophenone-based photopolymerization initiators, and thioxanthone-based photopolymerization initiators.

Specific examples of ketal-based photopolymerization initiators include 2,2-dimethoxy-1,2-diphenylethane-1-one (e.g. trade name "IRGACURE 651" available from BASF Corporation).

Specific examples of acetophenone-based photopolymerization initiators include 1-hydroxycyclohexyl phenyl ketone (e.g. trade name "IRGACURE 184" available from BASF Corporation), 4-phenoxydichloroacetophenone, 4-t-butyl-dichloroacetophenone, 1-[4-(2-hydroxyethoxy)-phenyl]-2-hydroxy-2-methyl-1-propane-1-one (e.g. trade name "IRGACURE 2959" available from BASF Corporation), and 2-hydroxy-2-methyl-1-phenyl-propane-1-one (e.g. trade name "DAROCUR 1173" available from BASF Corporation), methoxyacetophenone.

Specific examples of benzoin ether-based photopolymerization initiators include benzoin ethers such as benzoin methyl ether, benzoin ethyl ether, benzoin propyl ether, benzoin isopropyl ether, benzoin isobutyl ether, etc., as well as substituted benzoin ethers such as anisole methyl ether.

Specific examples of acylphosphine oxide-based photopolymerization initiators include bis(2,4,6-trimethylbenzoyl)phenylphosphine oxide (e.g. trade name "IRGACURE 819" available from BASF Corporation), bis(2,4,6-trimethylbenzoyl)-2,4-di-n-butoxyphenylphosphine oxide, 2,4,6-trimethylbenzoyldiphenylphosphine oxide (e.g. trade name "LUCIRIN TPO" available from BASF Corporation), and bis(2,6-dimethoxybenzoyl)-2,4,4-trimethylpentylphosphine oxide.

Specific examples of $\alpha$-ketol-based photopolymerization initiators include 2-methyl-2-hydroxypropiophenone, and 1-[4-(2-hydroxyethyl)phenyl]-2-methylpropane-1-one. Specific examples of aromatic sulfonyl chloride-based photopolymerization initiators include 2-naphthalenesulfonyl chloride. Specific examples of photoactive oxime-based photopolymerization initiators include 1-phenyl-1,1-propanedione-2-(o-ethoxycarbonyl)-oxime. Specific examples of benzoin-based photopolymerization initiators include benzoin. Specific examples of benzil-based photopolymerization initiators include benzil.

Specific examples of benzophenone-based photopolymerization initiators include benzophenone, benzoylbenzoic acid, 3,3'-dimethyl-4-methoxybenzophenone, polyvinylbenzophenone, and $\alpha$-hydroxycyclohexylphenylketone.

Specific examples of thioxanthone-based photopolymerization initiators include thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, isopropylthioxanthone, 2,4-diisopropylthioxanthone, and dodecylthioxanthone.

Such thermal polymerization initiator or photopolymerization initiator can be used in a usual amount in accordance with the polymerization method, embodiment of polymerization, etc., and there are no particular limitations to the amount. For instance, relative to 100 parts by weight of monomers to be polymerized, about 0.001 part to 5 parts by weight (typically about 0.01 part to 2 parts by weight, e.g. about 0.01 part to 1 part by weight) of polymerization initiator can be used.

(PSA composition comprising monomers in a fully-polymerized form)

The PSA composition according to a preferable embodiment comprises the monomers as a fully-polymerized product. Such a PSA composition may be in a form of, for instance, a solvent-based composition comprising in an organic solvent an acrylic polymer which is the fully-polymerized product of the monomers, a water-dispersed PSA composition such that the acrylic polymer is dispersed in an aqueous solvent. As used herein, the term "fully-polymerized product" refers to a product whose monomer conversion is above 95 % by weight.

(PSA composition comprising polymerized and unpolymerized (unreacted) monomers)

The PSA composition according to another preferable embodiment comprises a polymerization product of a monomer mixture comprising at least some of the monomers (starting monomers) that constitute the composition. Typically, of the monomers, some are included as a polymerized product and the rest are included as unreacted monomers. The polymerization product of the monomer mixture can be prepared by polymerizing the monomer mixture at least partially.

The polymerization product is preferably a partially-polymerized product of the monomer mixture. Such a partially-polymerized product is a mixture of a polymer formed from the monomer mixture and unreacted monomers, and it is typically in a form of syrup (viscous liquid). Hereinafter, a partially-polymerized product having such a form may be referred to as "monomer syrup" or simply "syrup."

The polymerization method for obtaining the polymerization product from the monomers is not particularly limited. A suitable method can be selected and employed among various polymerization methods as those described earlier. From the standpoint of the efficiency and convenience, a photopolymerization method can be preferably employed. According to a photopolymerization, depending on the polymerization conditions such as irradiation light quantity, etc., the polymer conversion of the monomer mixture can be easily controlled.

With respect to the partially-polymerized product, the monomer conversion of the monomer mixture is not particularly limited. The monomer conversion can be, for instance, about 70 % by weight or lower, or preferably about 60 % by weight or lower. From the standpoint of facile preparation of the PSA composition comprising the partially-polymerized product and ease of application, etc., the monomer conversion is usually suitably about 50 % by weight or lower, or preferably about 40 % by weight or lower (e.g. about 35 % by weight or lower). The lower limit of monomer conversion is not particularly limited. It is typically about 1 % by weight or higher, or usually suitably about 5 % by weight or higher.

The PSA composition comprising a partially-polymerized product of the monomer mixture can be easily obtained, for instance, by partially polymerizing a monomer mixture comprising all the starting monomers in accordance with a suitable polymerization method (e.g. photopolymerization). To the PSA composition comprising the partially-polymerized product, other components (e.g. photopolymerization initiator, polyfunctional monomer(s), crosslinking agent, acrylic oligomer described later, etc.) may be added as necessary. Methods for adding such other components are not particularly limited. For instance, they can be added to the monomer mixture in advance or added to the partially-polymerized product.

The PSA composition disclosed herein may also be in a form where a fully-polymerized product of a monomer mixture comprising certain species (starting monomers) among the monomers is dissolved in the rest of the monomers (unreacted) or a partially-polymerized product thereof. A PSA composition in such a form is also included in examples of the PSA composition comprising polymerized and non-polymerized (unreacted) monomers.

When forming PSA from a PSA composition comprising polymerized and non-polymerized monomers, a photopolymerization method can be preferably employed as the curing method (polymerization method). With respect to a PSA composition comprising a polymerization product prepared by a photopolymerization method, it is particularly preferable to employ photopolymerization as the curing method. A polymerization product obtained by photopolymerization already contains a photopolymerization initiator. When the PSA composition comprising the polymerization product is cured to form PSA, the photo-curing can be carried out without any additional photopolymerization initiator. Alternatively, the PSA composition may be obtained by adding a photopolymerization initiator as necessary to the polymerization product prepared by photopolymerization. The additional photopolymerization initiator may be the same as or different from the photopolymerization initiator used in preparing the polymerization product. If the PSA composition is prepared by a method other than photopolymerization, a photopolymerization initiator can be added to make it light-curable. The light-curable PSA composition is advantageous as it can readily form even a thick PSA layer. In a preferable embodiment, the PSA composition can be photopolymerized by UV irradiation to form a PSA. The UV irradiation may be performed using a commonly-known high-pressure mercury lamp, low-pressure mercury lamp, metal halide lamp, or the like.

(Crosslinking agent)

The PSA composition (preferably a solvent-based PSA composition) used for forming the PSA layer preferably includes a crosslinking agent as an optional component. The inclusion of the crosslinking agent can enhance the cohesion of PSA. It may be advantageous to have higher cohesion from the standpoint of preventing undesired lifting. The PSA layer in the art disclosed herein may include the crosslinking agent in a post-crosslinking-reaction form, a pre-crosslinking-reaction form, a partially crosslinked form, an intermediate or composite form of these, and so on. The PSA layer usually includes the crosslinking agent mostly in the post-crosslinking-reaction form.

The type of crosslinking agent is not particularly limited. A suitable species can be selected and used among heretofore known crosslinking agents. Examples of such crosslinking agents include isocyanate-based crosslinking agents, epoxy-based crosslinking agents, oxazoline-based crosslinking agents, aziridine-based crosslinking agents, melamine-based crosslinking agents, carbodiimide-based crosslinking agents, hydrazine-based crosslinking agents, amine-based crosslinking agents, peroxide-based crosslinking agents, metal chelate-based crosslinking agents, metal alkoxide-based crosslinking agents, and metal salt-based crosslinking agents. For the crosslinking agent, solely one species or a combination of two or more species can be used. Examples of crosslinking agents that can be preferably used in the art disclosed herein include isocyanate-based crosslinking agents and epoxy-based crosslinking agents.

As the epoxy-based crosslinking agent, a compound having at least two epoxy groups per molecule can be used without particular limitations. A preferable epoxy-based crosslinking agent has three to five epoxy groups per molecule. For the epoxy-based crosslinking agent, solely one species or a combination of two or more species can be used. Specific examples of the epoxy-based crosslinking agent include N,N,N',N'-tetraglycidyl-m-xylenediamine, 1,3-bis(N,N-diglycidylaminomethyl)cyclohexane, 1,6-hexanediol diglycidyl ether, polyethylene glycol diglycidyl ether, and polyglycerol polyglycidyl ether. Commercial epoxy-based crosslinking agents include trade names TETRAD-C and TETRAD-X available from Mitsubishi Gas Chemical Co., Inc.; trade name EPICLOM CR-5L available from DIC Corporation; trade name DENACOL EX-512 available from Nagase ChemteX Corporation; and trade name TEPIC-G available from Nissan Chemical Industries, Ltd.

In an embodiment using an epoxy-based crosslinking agent, its amount used is not particularly limited. The epoxy-based crosslinking agent used can be used in an amount of, for instance, more than 0 part by weight and about 1 part by weight or less (preferably about 0.001 part to 0.5 part by weight) to 100 parts by weight of the acrylic polymer. From the standpoint of favorably obtaining the effect to enhance cohesion, the epoxy-based crosslinking agent is used in an amount of usually suitably about 0.002 part by weight or greater to 100 parts by weight of the acrylic polymer, preferably about 0.005 part by weight or greater, more preferably about 0.01 part by weight or greater, yet more preferably about 0.02 part by weight or greater, or particularly preferably about 0.03 part by weight or greater. From the standpoint of avoiding lowering of initial adhesion to adherends due to excessive crosslinking, the epoxy-based crosslinking agent is used in an amount of usually suitably about 0.2 part by weight or less to 100 parts by weight of the acrylic polymer, or preferably about 0.1 part by weight or less.

As the isocyanate-based crosslinking agent, a polyfunctional isocyanate (which refers to a compound having an average of two or more isocyanate groups per molecule, including a compound having an isocyanurate structure) can be preferably used. For the isocyanate-based crosslinking agent, solely one species or a combination of two or more species can be used. A preferable example of the polyfunctional isocyanate has an average of three or more isocyanate groups per molecule. Such a tri-functional or higher polyfunctional isocyanate can be a multimer (e.g. a dimer or a trimer), a derivative (e.g., an addition product of a polyol and two or more polyfunctional isocyanate molecules), a polymer or the like of a di-functional, tri-functional, or higher polyfunctional isocyanate. Examples include polyfunctional isocyanates such as a dimer and a trimer of a diphenylmethane diisocyanate, an isocyanurate (a cyclic trimer) of a hexamethylene diisocyanate, a reaction product of trimethylol propane and a tolylene diisocyanate, a reaction product of trimethylol propane and a hexamethylene diisocyanate, polymethylene polyphenyl isocyanate, polyether polyisocyanate, and polyester polyisocyanate. Commercial products include trade name DURANATE TPA-100 available from Asahi Kasei Chemicals Corporation and trade names CORONATE L, CORONATE HL, CORONATE HK, CORONATE HX, and CORONATE 2096 available from Tosoh Corporation.

In an embodiment using an isocyanate-based crosslinking agent, its amount used is not particularly limited. The isocyanate-based crosslinking agent can be used in an amount of, for instance, about 0.5 part by weight or greater and about 10 parts by weight or less to 100 parts by weight of the acrylic polymer. From the standpoint of the cohesion, the isocyanate-based crosslinking agent is used in an amount of usually suitably about 1 part by weight or greater to 100 parts by weight of the acrylic polymer, or preferably about 1.5 parts by weight or greater. The isocyanate-based crosslinking agent is used in an amount of usually suitably about 8 parts by weight or less to 100 parts by weight of the acrylic polymer, or preferably about 5 parts by weight or less (e.g. less than about 4 parts by weight).

The art disclosed herein can be preferably implemented in an embodiment using an epoxy-based crosslinking agent as the crosslinking agent. In a preferable embodiment, the PSA composition includes an epoxy-based crosslinking agent as the crosslinking agent, but it is essentially free of an isocyanate-based crosslinking agent. As the crosslinking agent, an epoxy-based crosslinking agent can be used solely as well.

The crosslinking agent content (its total amount) in the PSA composition disclosed herein is not particularly limited. From the standpoint of the cohesion, the crosslinking agent content is usually about 0.001 part by weight or greater to 100 parts by weight of the acrylic polymer, suitably about 0.002 part by weight or greater, preferably about 0.005 part by weight or greater, more preferably about 0.01 part by weight or greater, yet more preferably about 0.02 part by weight or greater, or particularly preferably about 0.03 part by weight or greater. From the standpoint of the initial adhesion to adherends, the crosslinking agent content in the PSA composition is usually about 20 parts by weight or less to 100 parts by weight of the acrylic polymer, suitably about 15 parts by weight or less, or preferably about 10 parts by weight or less (e.g. about 5 parts by weight or less).

(Tackifier resin)

In a preferable embodiment, the PSA composition (and even the PSA layer) includes a tackifier resin. As the tackifier resin possibly included in the PSA composition, one, two or more species can be selected and used among various known tackifier resins such as phenolic tackifier resins, terpene-based tackifier resins, modified terpene-based tackifier resins, rosin-based tackifier resins, hydrocarbon-based tackifier resins, epoxy-based tackifier resins, polyamide-based tackifier resins, elastomer-based tackifier resins, and ketone-based tackifier resins. The use of tackifier resin enhances adhesive strength including initial adhesive strength to adherends.

Examples of the phenolic tackifier resin include terpene-phenol resin, hydrogenated terpene-phenol resin, alkylphenol resin and rosin-phenol resin.

The terpene-phenol resin refers to a polymer comprising a terpene residue and a phenol residue, and its concept encompasses copolymer of a terpene and a phenol compound (terpene-phenol copolymer resin) as well as a terpene or its homopolymer or copolymer modified with phenol (phenol-modified terpene resin). Preferable examples of a terpene forming such terpene-phenol resin include monoterpenes such as $\alpha$-pinene, $\beta$-pinene, limonenes (including d limonene, 1 limonene and d/1 limonene (dipentene)). The hydrogenated terpene-phenol resin refers to a hydrogenated terpene-phenol resin having a hydrogenated structure of such terpene-phenol resin. It is sometimes called hydrogenated terpene-phenol resin.

The alkylphenol resin is a resin (oil phenol resin) obtainable from an alkylphenol and formaldehyde. Examples of the alkylphenol resin include a novolac type and a resol type.

The rosin-phenol resin is typically a resin obtainable by phenol modification of a rosin or one of the various rosin derivatives listed above (including a rosin ester, an unsaturated fatty acid-modified rosin and an unsaturated fatty acid-modified rosin ester). Examples of the rosin-phenol resin include a rosin-phenol resin obtainable by acid catalyzed addition of a phenol to a rosin or one of the various rosin derivatives listed above followed by thermal polymerization, etc.

Among these phenolic tackifier resins, terpene-phenol resin, hydrogenated terpene-phenol resin and alkyl phenol resin are preferable; terpene-phenol resin and hydrogenated terpene-phenol resin are more preferable; in particular, terpene-phenol resin is preferable.

Examples of terpene-based tackifier resin include terpenes (typically monoterpenes) such as $\alpha$-pinene, $\beta$-pinene, d-limonene, 1-limonene, and dipentene. It can be homopolymer of one species of terpene or copolymer of two or more species of terpene. Examples of the homopolymer of one species of terpene include $\alpha$-pinene polymer, $\beta$-pinene polymer, and dipentene polymer.

Examples of modified terpene resin include resins obtainable by modification of the terpene resins. Specific examples include styrene-modified terpene resin and hydrogenated terpene resins.

The concept of rosin-based tackifier resin here encompasses both rosins and rosin derivative resins. Examples of rosins include unmodified rosins (raw rosins) such as gum rosin, wood rosin, and tall-oil rosin; and modified rosins obtainable from these unmodified rosins via modifications such as hydrogenation, disproportionation, and polymerization (hydrogenated rosins, disproportionated rosins, polymerized rosins, other chemically-modified rosins, etc.).

The rosin derivative resin is typically a derivative of a rosin as those listed above. The concept of rosin-based resin herein encompasses a derivative of an unmodified rosin and a derivative of a modified rosin (including a hydrogenated rosin, a disproportionated rosin, and a polymerized rosin). Examples of the rosin derivative resin include rosin esters such as an unmodified rosin ester which is an ester of an unmodified rosin and an alcohol, and a modified rosin ester which is an ester of a modified rosin and an alcohol; an unsaturated fatty acid-modified rosin obtainable by modifying a rosin with an unsaturated fatty acid; an unsaturated fatty acid-modified rosin ester obtainable by modifying a rosin ester with an unsaturated fatty acid; rosin alcohols obtainable by reduction of carboxy groups in rosins or aforementioned various rosin derivatives (including rosin esters, unsaturated fatty acid-modified rosin, and an unsaturated fatty acid-modified rosin ester); and metal salts of rosins or aforementioned various rosin derivatives. Specific examples of rosin esters include a methyl ester of an unmodified rosin or a modified rosin (hydrogenated rosin, disproportionated rosin, polymerized rosin, etc.), triethylene glycol ester, glycerin ester, and pentaerythritol ester.

Examples of hydrocarbon-based tackifier resin include various types of hydrocarbon-based resins such as aliphatic hydrocarbon resins, aromatic hydrocarbon resins, alicyclic hydrocarbon resins, aliphatic/aromatic petroleum resins (styrene-olefin-based copolymer, etc.), aliphatic/alicyclic petroleum resins, hydrogenated hydrocarbon resins, coumarone-based resins, and coumarone-indene-based resins.

The softening point of the tackifier resin is not particularly limited. From the standpoint of obtaining greater cohesion, it is preferable to use a tackifier resin having a softening point (softening temperature) of about 80 °C or higher (preferably about 100 °C or higher). For instance, a phenolic tackifier resin (terpene-phenol resin, etc.) having such a softening point can be preferably used. In a preferable embodiment, a terpene-phenol resin having a softening point of about 135 °C or higher (or even about 140 °C or higher) can be used. The maximum softening point of the tackifier resin is not particularly limited. From the standpoint of the tightness of adhesion to adherend and substrate film, it is preferable to use a tackifier resin having a softening point of about 200 °C or lower (more preferably about 180 °C or lower). The softening point of a tackifier resin can be determined based on the softening point test method (ring and ball method) specified in JIS K2207.

In a preferable embodiment, the tackifier resin includes one, two or more species of phenolic tackifier resins (e.g. terpene-phenol resin). The art disclosed herein can be preferably implemented, for instance, in an embodiment where the terpene-phenol resin accounts for about 25 % by weight or more (more preferably about 30 % by weight or more) of the total amount of the tackifier resin. The terpene-phenol resin may account for about 50 % by weight or more of the total amount of the tackifier resin, or about 80 % by weight or more (e.g. about 90 % by weight or more) thereof. Essentially all (e.g. about 95 % by weight or more and 100 % by weight or less, or even about 99 % by weight or more and 100 % by weight or less) of the tackifier resin can be the terpene-phenol resin.

In an embodiment using a tackifier resin, the tackifier resin content is not particularly limited. It can be selected in accordance with the purpose and way of using the PSA sheet. The tackifier resin content can be about 5 parts by weight or greater to 100 parts by weight of the acrylic polymer; it can also be about 8 parts by weight or greater (e.g. about 10 parts by weight or greater). The art disclosed herein can be preferably implemented in an embodiment where the tackifier resin content to 100 parts by weight of the acrylic polymer is about 15 parts by weight or greater. The maximum tackifier resin content is not particularly limited. From the standpoint of the compatibility with the acrylic polymer and deformation resistance, the tackifier resin content relative to 100 parts by weight of the acrylic polymer is suitably about 70 parts by weight or less, preferably about 55 parts by weight or less, or more preferably about 45 parts by weight or less (e.g. about 40 parts by weight or less, typically about 30 parts by weight or less).

(Other additives)

The PSA composition may comprise, as necessary, various additives generally known in the field of PSA, such as leveling agent, crosslinking accelerator, plasticizer, softener, anti-static agent, anti-aging agent, UV absorber, antioxidant and photo-stabilizer. With respect to these various additives, heretofore known species can be used by typical methods. As they do not characterize the present invention in particular, details are omitted.

The PSA layer disclosed herein may be formed from an aqueous PSA composition, solvent-based PSA composition, hot-melt PSA composition, or active energy ray-curable PSA composition. The aqueous PSA composition refers to a PSA composition comprising a PSA (PSA layer-forming components) in a solvent primarily comprising water (an aqueous solvent) and may typically be what is called a water-dispersed PSA composition (a composition in which the PSA is at least partially dispersed in water). The solvent-based PSA composition refers to a PSA composition comprising a PSA in an organic solvent. From the standpoint of adhesive properties, etc., the art disclosed herein is preferably implemented in an embodiment comprising a PSA layer formed from a solvent-based PSA composition.

The PSA sheet disclosed herein can be formed by a heretofore known method. As the method for forming a substrate-free PSA sheet formed of a PSA layer, for instance, it is possible to employ a direct method where the PSA composition is directly provided (typically applied) to the first or second release film and allowed to dry or cure to form a PSA layer on the release film. Alternatively, it is also possible to employ a transfer method where the PSA composition is provided to a release face different from the first and second release film and allowed to dry or cure to form a PSA layer on the surface, and the PSA layer is transferred to the first or second release film. In either the direction method or transfer method, the exposed face of the PSA layer is covered with the other release film to form a double-linered PSA sheet. When forming the PSA sheet by the direct method, it is preferable to provide the PSA composition to the second release film which has a higher tensile elastic modulus and is easier to handle. The PSA layer disclosed herein is not limited to, but typically formed in a continuous form. For instance, the PSA layer may be formed in a regular or random pattern of dots, stripes, etc.

The PSA composition can be applied using a heretofore known coater, for instance, gravure coater, die coater and bar coater. Alternatively, the PSA composition can also be applied by impregnation, curtain coating, etc.

From the standpoint of accelerating the crosslinking reaction and increasing the productivity of manufacturing, the PSA composition is preferably dried with heating. The drying temperature can be, for instance, about 40 °C to 150 °C, or usually preferably about 60 °C to 130 °C. After dried, the PSA composition may be aged for purposes such as adjusting the migration of components in the PSA layer and the progress of the crosslinking reaction, and lessening deformation possibly present in the substrate film and the PSA layer.

The thickness of the PSA layer is not particularly limited. The thickness of the PSA layer is usually suitably about 300 $\mu$m or less, preferably about 200 $\mu$m or less, more preferably about 150 $\mu$m or less, or yet more preferably about 100 $\mu$m or less. In the PSA sheet according to a preferable embodiment, the PSA layer has a thickness of about 50 $\mu$m or less (typically 40 $\mu$m or less). The minimum thickness of the PSA layer is not particularly limited. From the standpoint of the adhesion and adherend conformability, it is advantageously about 3 $\mu$m or greater, preferably about 6 $\mu$m or greater, or more preferably about 10 $\mu$m or greater (e.g. about 15 $\mu$m or greater). For instance, the double-linered PSA sheet disclosed herein can be favorably made in an embodiment where the PSA sheet comprises a PSA layer having a thickness of about 10 $\mu$m or greater and about 150 $\mu$m or less (preferably about 15 $\mu$m or greater and about 50 $\mu$m or less, e.g. 20 $\mu$m or greater and 50 $\mu$m or less). A favorable example is a double-linered PSA sheet in which the PSA sheet is a substrate-free PSA sheet formed solely of a PSA layer having such a thickness.

The double-linered PSA sheet disclosed herein can be favorably made in an embodiment where the PSA layer forming the PSA sheet has a storage modulus at 25 °C, G'(25°C), of 0.6 MPa or less. A low storage modulus G' of the PSA layer may be advantageous from the standpoint of enhancing initial adhesion to adherends. On the other hand, it tends to be more likely to cause undesired lifting of the PSA sheet. Accordingly, it is greatly significant to apply the art disclosed herein to reduce undesired lifting. The G'(25°C) can be, for instance, 0.4 MPa or less, 0.3 MPa or less, 0.25 MPa or less, or sometimes even 0.23 MPa or less. The minimum G'(25°C) value is not particularly limited. From the standpoint of obtaining cohesive strength suited for fixing parts, it is usually suitably 0.12 MPa or greater. In some embodiments, the G'(25°C) can be 0.15 MPa or greater, or even 0.17 MPa or greater.

The storage modulus G'(25°C) of the PSA layer can be determined by dynamic elastic modulus measurement. In particular, several layers of the PSA (the PSA sheet in case of a substrate-free PSA sheet) of interest are layered to fabricate an approximately 2 mm thick PSA layer. A specimen obtained by punching out a disc of 7.9 mm diameter from the PSA layer is fixed between parallel plates. With a rheometer (e.g. ARES available from TA Instruments or a comparable system), dynamic elastic modulus measurement is carried out to determine the storage modulus G'(25°C).

- Measurement mode: shear mode
- Temperature range: -70 °C to 150 °C
- Heating rate: 5 °C/min
- Measurement frequency: 1 Hz

The same measurement method is also used in the working examples described later.

<Substrate>

In an embodiment where the PSA sheet disclosed herein is a single-faced or double-faced on-substrate PSA sheet, as the substrate to support (back) the PSA layer(s), a resin film, foam film, paper, fabrics, metal foil, a composite of these and the like can be used. Examples of the resin film include polyolefin films such as polyethylene (PE), polypropylene (PP), and ethylene-propylene copolymer; polyester films such as polyethylene terephthalate (PET); polyvinyl resin films; vinyl acetate resin films; polyimide resin films; polyamide resin films; fluororesin films; and cellophane. Examples of the paper that can be used in the substrate film include Japanese paper, Kraft paper, glassine paper, high-grade paper, synthetic paper, and top-coated paper. Examples of fabrics include woven fabrics and nonwoven fabrics of pure or blended yarn of various fibrous materials. Examples of fibrous materials include cotton, staple cloth, Manila hemp, pulp, rayon, acetate fiber, polyester fiber, polyvinyl alcohol fiber, polyamide fiber, and polyolefin fiber. Examples of rubber sheets include natural rubber sheets and butyl rubber sheets. Examples of foam sheets include polyurethane foam sheets and polychloroprene rubber foam sheets. Examples of metal foil that can be used in the substrate film include aluminum foil and copper foil.

The concept of non-woven fabric as used herein primarily refers to non-woven fabric for PSA sheets used in the field of PSA tapes and other PSA sheets, typically referring to non-woven fabric (or so-called "paper") fabricated using a general paper machine. Resin film herein is typically a non-porous resin sheet and its concept is distinct from, for instance, non-woven fabric (i.e. excludes non-woven fabric). The resin film may be any of non-stretched film, uni-axially stretched film and bi-axially stretched film. The substrate's surface to be provided with a PSA layer may be subjected to a surface treatment such as primer coating, corona discharge treatment, and plasma treatment.

The thickness of the substrate film disclosed herein is not particularly limited. From the standpoint of avoiding making the PSA sheet excessively thick, the thickness of the substrate film (e.g. resin film) can be, for instance, about 200 $\mu$m or less, preferably about 150 $\mu$m or less, or more preferably about 100 $\mu$m or less. In accordance with the purpose and the way of using the PSA sheet, the thickness of the substrate film can be about 70 $\mu$m or less, about 50 $\mu$m or less, or even about 30 $\mu$m or less (e.g. about 25 $\mu$m or less). In an embodiment, the thickness of the substrate film can be about 20 μm or less, about 15 μm or less, or even about 10 μm or less (e.g. about 5 μm or less). The thickness of the substrate film can be reduced to increase the thickness of the PSA layer without changing the total thickness of the PSA sheet. This may be advantageous from the standpoint of enhancing the tightness of adhesion to the substrate. The minimum thickness of the substrate film is not particularly limited. From the standpoint of the ease of handling and processing the PSA sheet, etc., the thickness of the substrate film is usually about 0.5 μm or greater (e.g. 1 μm or greater), or preferably about 2 μm or greater, for instance, about 4 μm or greater. In an embodiment, the thickness of the substrate film can be about 6 μm or greater, about 8 μm or greater, or even about 10 μm or greater (e.g. greater than 10 μm).

<Applications>

In the double-linered PSA sheet disclosed herein, both the first and second adhesive faces are protected with release films. Thus, it is suited for surface smoothening and may quickly form good adhesion with adherends. Such a PSA sheet is likely to perform well even in a small area and may provide excellent initial adhesion to adherends as well. With the double-linered PSA sheet disclosed herein, undesired lifting of the PSA sheet is well prevented when removing the first release film and the PSA sheet can be easily transferred to an adherend. Because of these features, the double-linered PSA sheet can be used in various applications for which initial adhesion and high ease of transfer to adherends are desired. For instance, it can be preferably used for fixing various parts by quick press-bonding and for an application where adhesion to a final adherend is carried out after the PSA sheet is processed into a complex or precise shape in a multi-stage process including its transfer onto a process liner. A typical example is fixing parts of various electronics that are produced in mass and thus under strict takt time management and for which shapes of PSA sheets tend to be complex with decreasing product size, increasing screen size, sophisticating designs, etc. For instance, the double-linered PSA sheet disclosed herein can be preferably applied for fixing parts in various types of mobile devices (portable devices). Non-limiting examples of the mobile electronics include mobile phones, smartphones, tablet PCs, notebook PCs, various wearable devices (e.g. wrist wearables put on wrists such as wrist watches; modular devices attached to bodies with clips, straps, etc.; eye wears including eye glass types (monocular or binocular, including head-mounted pieces); clothing types worn as, for instance, accessories on shirts, socks, hats/caps, etc.; ear-mounted pieces put on ears such as earphones), digital cameras, digital video cameras, acoustic equipment (portable music players, IC recorders, etc.), calculators (e.g. pocket calculators), handheld game devices, electronic dictionaries, electronic notebooks, electronic books, vehicle navigation devices, portable radios, portable TVs, portable printers, portable scanners, and portable modems. In this description, to be "mobile (portable)," it is unsatisfactory to be simply capable of being carried. Instead, it indicates a level of mobility (portability) that allows for relatively easy carriage by hand of an individual (a typical adult).

Matters disclosed by this description include the following:

(1) A double-linered PSA sheet having an adhesively double-faced PSA sheet, a first release film placed on a first adhesive face of the PSA sheet, and a second release film placed on a second adhesive face of the PSA sheet, wherein

the first and second release films have tensile elastic moduli $E_1$ and $E_2$ at an $E_2/E_1$ ratio value of 1.5 or greater (e.g. 1.5 or greater and 50 or less).

(2) The double-linered PSA sheet according to (1) above, wherein the first and second release films have peel strength $R_1$ and $R_2$ with a difference in peel strength, $R_2 - R_1$, of 0.2 N/50mm or less (e.g. 0.01 N/50mm or greater and 0.2 N/50mm or less).

(3) The double-linered PSA sheet according to (1) or (2) above, wherein the first release film has a maximum test strength $F_1$ of 5 N or greater (e.g. 5 N or greater and 120 N or less) in a tensile test.

(4) The double-linered PSA sheet according to any of (1) to (3) above, wherein the second release film has a maximum test strength $F_2$ of 30 N or greater (e.g. 30 N or greater and 200 N or less) in a tensile test.

(5) The double-linered PSA sheet according to any of (1) to (4) above, wherein the first release film is a releasable polyolefin film.

(6) The double-linered PSA sheet according to any of (1) to (5) above, wherein the second release film is a releasable polyester film.

(7) The double-linered PSA sheet according to any of (1) to (5) above, wherein the first release film is a releasable polyethylene film and the second release film is selected from the group consisting of releasable polypropylene films and releasable polyester films.

(8) The double-linered PSA sheet according to any of (1) to (7) above, wherein one or each of the first and second release films is colored.

(9) The double-linered PSA sheet according to any of (1) to (8) above, wherein the PSA sheet is formed of a PSA layer having a storage modulus at 25 °C, G'(25°C), of 0.6 MPa or less (e.g. 0.15 MPa or greater and 0.60 MPa or less), 0.40 MPa or less, or 0.30 MPa or less.

(10) The double-linered PSA sheet according to any of (1) to (9) above, wherein the PSA sheet is a substrate-free PSA sheet formed of a PSA layer.

(11) The double-linered PSA sheet according to any of (1) to (10) above, wherein the PSA sheet comprises an acrylic PSA layer.

(12) The double-linered PSA sheet according to any of (1) to (11) above, wherein the second release film has a peel strength $R_2$ of 0.4 N/50mm or less (e.g. 0.01 N/50mm or greater and 0.4 N/50mm or less).

(13) The double-linered PSA sheet according to any of (1) to (12) above, wherein the first release film has a peel strength $R_1$ of 0.3 N/50mm or less (e.g. 0.01 N/50mm or greater and 0.3 N/50mm or less).

(14) The double-linered PSA sheet according to any of (1) to (13) above, wherein the first release film has a thickness $t_1$ of 20 μm or greater (e.g. 20 μm or greater and 150 μm or less).

(15) The double-linered PSA sheet according to any of (1) to (14) above, wherein the first and second release film have thicknesses $t_1$ and $t_2$ at a $t_1$ to $t_2$ ratio of greater than 1 and 5 or less.

(16) The double-linered PSA sheet according to any of (1) to (15) above, wherein the PSA layer has a thickness of 20 μm or greater (e.g. 20 μm or greater and 200 μm or less).

(17) The double-linered PSA sheet according to any of (1) to (16) above, used for fixing a part in a mobile electronic device.

(18) The double-linered PSA sheet according to any of (1) to (17) above, used for fixing a part by applying the first adhesive face to the part.

(19) The double-linered PSA sheet according to any of (1) to (18) above, used in an embodiment where it is transferred to a releasable surface by applying the first adhesive face to the releasable surface.

EXAMPLES

Several working examples related to the present invention are described below, but the present invention is not intended to be limited to these specific examples. In the description below, "parts" and "%" are by weight unless otherwise specified.

<Preparation of PSA composition>

(PSA composition A)

In a reaction vessel equipped with a stirrer, thermometer, nitrogen inlet, reflux condenser and addition funnel, were placed 90 parts of 2EHA and 10 parts of AA as monomers as well as ethyl acetate and toluene at about 1:1 (volume ratio) as polymerization solvents. The resulting mixture was stirred under a nitrogen flow for two hours. After oxygen was removed from the polymerization system in such a manner, was added 0.2 part of BPO as a polymerization initiator. Polymerization was carried out at 60 °C for 6 hours to obtain a solution of acrylic polymer A. The acrylic polymer A had a Mw of $94.6 \times 10^4$. To the resulting acrylic polymer solution, were added 0.05 part of epoxy-based crosslinking agent (product name TETRAD-C, 1,3-bis(N,N-diglycidylaminomethyl)cyclohexane, available from Mitsubishi Gas Chemical Co., Ltd.) and 20 parts of terpene-phenol resin (product name TAMANOL 803L, available from Arakawa Chemical Industries, Ltd.; softening point: around 145 °C to 160 °C) to 100 parts of acrylic polymer A in the solution. The resultant was mixed with stirring to prepare a PSA composition A.

(PSA composition B)

The monomer composition was changed to 95 parts BA and 5 parts AA. Otherwise, basically in the same manner as the preparation of the PSA composition A, was obtained a solution of acrylic polymer B and was prepared a PSA composition B. The acrylic polymer B had a Mw of $68 \times 10^4$.

<Fabrication of double-linered PSA sheet>

(Release films)

Were obtained a total of six different release films as follows: two kinds of release films (PE #50, PE #80) each having a release layer treated with a silicone-based release agent on one face of an LDPE film, a release film (OPP #80) having a release layer treated with a silicone-based release agent on one face of an OPP film, and three kinds of release films (PET #25, PET #38, PET #75) each having a release layer treated with a silicone-based release agent on one face of a PET film. Table 1 shows the compositions and properties of the respective release films.

[Table 1]

Table 1

| Release film | Resin type | Thickness (μm) | Tensile elastic modulus (GPa) | Maximum test strength (N) | Tensile strength (MPa) | Maximum strain point (%) | Peel strength (N/ 50mm) |
|---|---|---|---|---|---|---|---|
| PE#50 | PE | 50 | 0.2 | 9.4 | 18.7 | 233 | 0.11 |
| PE#80 | PE | 80 | 0.2 | 19.6 | 24.5 | 339 | 0.13 |
| OPP#80 | OPP | 80 | 1.1 | 91.1 | 113.8 | 222 | 0.14 |
| PET#25 | PET | 25 | 1.8 | 40.6 | 162.4 | 120 | 0.12 |
| PET#38 | PET | 38 | 2.1 | 71.2 | 187.5 | 140 | 0.15 |
| PET#75 | PET | 75 | 2.3 | 125.9 | 167.9 | 146 | 0.41 |

(Example 1)

To the release face of PET #38 as the second release film, was applied the PSA composition A and allowed to dry at 100 °C for two minutes to form a 30 μm thick PSA layer. The exposed adhesive face of the PSA layer was covered with PE #50 as the first release film with its release face on the PSA layer side. In such a manner, was fabricated a double-linered PSA sheet according to Example 1, with its substrate-free PSA sheet formed of the PSA layer having its first and second adhesive faces covered with the first and second release films (PE #50 and PE #38), respectively.

(Examples 2 to 12)

The PSA compositions, the first and second release films shown in Tables 2 and 3 were used. Otherwise in the same manner as Example 1, were fabricated double-linered PSA sheets according to Examples 2 to 12.
A PSA layer formed from the PSA composition A had a storage modulus G'(25°C) of 0.18 MPa. A PSA layer formed from the PSA composition B had a storage modulus G'(25°C) of 0.25 MPa.

<Evaluations>

(Evaluation of undesired lifting resistance)

Using a commercial double-faced PSA tape, the double-linered PSA sheet according to each Example was cut to a 50 mm wide,150 mm long strip to prepare a test piece. In an environment at 23 °C and 50 % RH, the backside of the second release film of each test piece was fixed to a stainless steel plate with a commercial double-faced PSA tape to fabricate a measurement sample. The sample was set in a universal tensile tester. At a tensile speed of 300 mm/min, at 180° peel strength, the first release film was peeled away. The behavior of the PSA sheet during this operation was observed and its undesired lifting resistance was graded according to the three grades shown below. The results are shown in Tables 2 and 3.

E: No deformation found in the PSA sheet (excellent undesired lifting resistance).
G: Some deformation found in the PSA sheet, but no lifting of the PSA sheet from the second release film (good undesired lifting resistance).
P: Part of the PSA sheet cut off from the rest and peeled away along with the first release film (poor undesired lifting resistance).

(Ease of transfer)

With respect to the double-linered PSA sheets according to the respective Examples except for Examples 7, 8, 11 and 12 in which undesired lifting occurred in the undesired lifting resistance test above, assuming an application involving a transfer to a release face of a process liner, the ease of transferring the PSA sheet from the second release film was evaluated.

In particular, was obtained a release film for testing ease of transfer, having a release layer treated with a silicone-based release agent on a 75 $\mu$m thick polyester resin film and showing a peel strength of 0.5 N/50mm. The backside of this release film was fixed to the stainless steel with the commercial double-faced PSA tape and the resultant was used as the adherend. The double-linered PSA sheet according to each Example was cut to a 20 mm wide strip to prepare a test piece. In an environment at 23 °C and 50 % RH, the first release film was removed from the test piece to expose the first adhesive face and the first adhesive face was press-bonded to the adherend (i.e. to the release face of the release film for testing ease of transfer) with a 2 kg roller moved back and forth once. At 5 minutes after the press-bonding, using a universal tensile tester, the second release film was peeled away at a tensile speed of 300 mm/min, at a peel angle of 180°. The behavior of the PSA sheet during this operation was observed and the PSA sheet was graded according to the two grades shown below. The results are shown in Tables 2 and 3.

G: The second release film was removed, leaving the entire PSA sheet on the adherend (good ease of transfer).
P: The PSA sheet peeled off along with the second release film and was not transferred to the adherend surface, or part of the PSA sheet was cut off from the rest and peeled off along with the second release film (poor ease of transfer).

[Table 2]

Table 2

| | | | Ex. 1 | Ex. 2 | Ex. 3 | Ex. 4 | Ex. 5 | Ex. 6 |
|---|---|---|---|---|---|---|---|---|
| Thickness of PSA sheet ($\mu$m) | | | 30 | 30 | 30 | 30 | 30 | 30 |
| PSA composition | | | A | A | A | B | B | B |
| First release film | Material | | PE | PE | OPP | PE | PE | OPP |
| | Thickness ($\mu$m) | | 50 | 80 | 80 | 50 | 80 | 80 |
| | Tensile elastic modulus $E_1$ (GPa) | | 0.2 | 0.2 | 1.1 | 0.2 | 0.2 | 1.1 |
| | Peel strength $R_1$ (N/50mm) | | 0.11 | 0.13 | 0.14 | 0.11 | 0.13 | 0.14 |
| Second release film | Material | | PET | PET | PET | PET | PET | PET |
| | Thickness ($\mu$m) | | 38 | 38 | 38 | 38 | 38 | 38 |
| | Tensile elastic modulus $E_2$ (GPa) | | 2.1 | 2.1 | 2.1 | 2.1 | 2.1 | 2.1 |
| | Peel strength $R_2$ (N/50mm) | | 0.15 | 0.15 | 0.15 | 0.15 | 0.15 | 0.15 |
| Elastic modulus ratio ($E_2/E_1$) | | | 10.5 | 10.5 | 1.9 | 10.5 | 10.5 | 1.9 |
| Difference in Peel strength ($R_2$-$R_1$) (N/50mm) | | | 0.04 | 0.02 | 0.01 | 0.04 | 0.02 | 0.01 |
| Undesired lifting resistance | | | E | E | G | E | E | G |
| Ease of transfer | | | G | G | G | G | G | G |

[Table 3]

Table 3

| | Ex. 7 | Ex. 8 | Ex. 9 | Ex. 10 | Ex. 11 | Ex. 12 |
|---|---|---|---|---|---|---|
| Thickness of PSA sheet ($\mu$m) | 30 | 30 | 30 | 30 | 30 | 30 |
| PSA composition | A | A | A | A | B | B |

(continued)

|  |  |  | Ex. 7 | Ex. 8 | Ex. 9 | Ex. 10 | Ex. 11 | Ex. 12 |
|---|---|---|---|---|---|---|---|---|
| First release film | | Material | PET | PET | PET | PET | PET | PET |
| | | Thickness ($\mu$m) | 38 | 25 | 38 | 25 | 38 | 25 |
| | | Tensile elastic modulus $E_1$ (GPa) | 2.1 | 1.8 | 2.1 | 1.8 | 2.1 | 1.8 |
| | | Peel strength $R_1$ (N/50mm) | 0.15 | 0.12 | 0.15 | 0.12 | 0.15 | 0.12 |
| Second release film | | Material | PET | PET | PET | PET | PET | PET |
| | | Thickness ($\mu$m) | 38 | 38 | 75 | 75 | 38 | 38 |
| | | Tensile elastic modulus $E_2$ (GPa) | 2.1 | 2.1 | 2.3 | 2.3 | 2.1 | 2.1 |
| | | Peel strength $R_2$ (N/50mm) | 0.15 | 0.15 | 0.41 | 0.41 | 0.15 | 0.15 |
| Elastic modulus ratio ($E_2/E_1$) | | | 1.0 | 1.2 | 1.1 | 1.3 | 1.0 | 1.2 |
| Difference in Peel strength ($R_2$-$R_1$) (N/50mm) | | | 0.00 | 0.03 | 0.26 | 0.29 | 0.00 | 0.03 |
| Undesired lifting resistance | | | P | P | E | E | P | P |
| Ease of transfer | | | n.m. | n.m. | P | P | n.m. | n.m. |
| *n.m. indicates "not measured." | | | | | | | | |

As shown in Tables 2 and 3, the double-linered PSA sheets of Examples 1 to 6 having elastic modulus ratio ($E_2/E_1$) values greater than 1.5 showed good undesired lifting resistance even when their peel strength difference ($R_2$ - $R_1$) values were 0.2 N/50mm or less. According to these double-linered PSA sheets, after the first release films were removed, the PSA sheets on the second release films were transferred adequately to the releasable surface.
On the other hand, with respect to the double-linered PSA sheet of Examples 7 to 12, undesired lifting resistance was insufficient at a peel strength difference ($R_2$ - $R_1$) of 0.2 N/50mm or less. Examples 9 and 10 with larger differences in peel strength ($R_2$ - $R_1$) lacked ease of transfer from the second release film to the releasable surface.
Although specific embodiments of the present invention have been described in detail above, these are merely for illustrations and do not limit the scope of claims. The art according to the claims includes various modifications and changes made to the specific embodiments illustrated above.

[Reference Signs List]

1, 3 PSA sheets
1A, 3A first face (first adhesive face)
1B, 3B second face (second adhesive face)
11 PSA layer
11A first surface
11B second surface
21 first release film
21A surface (first release face)
21B backside
22 second release film
22A surface (second release face)
31 first PSA layer
32 second PSA layer
35 support substrate
100, 300 double-linered PSA sheets

**Claims**

1.  A double-linered pressure-sensitive adhesive sheet having an adhesively double-faced pressure-sensitive adhesive sheet, a first release film placed on a first adhesive face of the pressure-sensitive adhesive sheet, and a second release film placed on a second adhesive face of the pressure-sensitive adhesive sheet, wherein the first and second release films have tensile elastic moduli $E_1$ and $E_2$ at an $E_2/E_1$ ratio value of 1.5 or greater.

2. The double-linered pressure-sensitive adhesive sheet according to Claim 1, wherein the first and second release films have peel strength $R_1$ and $R_2$ with a difference in peel strength, $R_2 - R_1$, of 0.2 N/50mm or less.

3. The double-linered pressure-sensitive adhesive sheet according to Claim 1 or 2, wherein the first release film has a maximum test strength $F_1$ of 5 N or greater in a tensile test.

4. The double-linered pressure-sensitive adhesive sheet according to any one of Claims 1 to 3, wherein the second release film has a maximum test strength $F_2$ of 30 N or greater in a tensile test.

5. The double-linered pressure-sensitive adhesive sheet according to any one of Claims 1 to 4, wherein the first release film is a releasable polyolefin film.

6. The double-linered pressure-sensitive adhesive sheet according to any one of Claims 1 to 5, wherein the second release film is a releasable polyester film.

7. The double-linered pressure-sensitive adhesive sheet according to any one of Claims 1 to 6, wherein the pressure-sensitive adhesive sheet is formed of a pressure-sensitive adhesive layer having a storage modulus at 25 °C, $G'(25°C)$, of 0.6 MPa or less.

8. The double-linered pressure-sensitive adhesive sheet according to any one of Claims 1 to 7, wherein the pressure-sensitive adhesive sheet is a substrate-free pressure-sensitive adhesive sheet formed of a pressure-sensitive adhesive layer.

9. The double-linered pressure-sensitive adhesive sheet according to any one of Claims 1 to 8, wherein the pressure-sensitive adhesive sheet comprises an acrylic pressure-sensitive adhesive layer.

10. The double-linered pressure-sensitive adhesive sheet according to any one of Claims 1 to 9, wherein the second release film has a peel strength $R_2$ of 0.4 N/50mm or less.

11. The double-linered pressure-sensitive adhesive sheet according to any one of Claims 1 to 10, wherein the first release film has a peel strength $R_1$ of 0.3 N/50mm or less.

12. The double-linered pressure-sensitive adhesive sheet according to any one of Claims 1 to 11, wherein the first release film has a thickness $t_1$ of 20 $\mu$m or greater.

13. The double-linered pressure-sensitive adhesive sheet according to any one of Claims 1 to 12, wherein the first and second release film have thicknesses $t_1$ and $t_2$ at a $t_1$ to $t_2$ ratio of greater than 1 and 5 or less.

14. The double-linered pressure-sensitive adhesive sheet according to any one of Claims 1 to 13, wherein the pressure-sensitive adhesive layer has a thickness of 20 $\mu$m or greater.

15. The double-linered pressure-sensitive adhesive sheet according to any one of Claims 1 to 14, used for fixing parts in mobile electronics.

[Fig. 1]

[Fig. 2]

Europäisches
Patentamt

European
Patent Office

Office européen
des brevets

**PARTIAL EUROPEAN SEARCH REPORT**

under Rule 62a and/or 63 of the European Patent Convention.
This report shall be considered, for the purposes of
subsequent proceedings, as the European search report

Application Number

EP 18 19 8699

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/189468 A1 (GIAMMARCO RALPH [US] ET AL) 25 July 2013 (2013-07-25)<br>* abstract *<br>* paragraphs [0026], [0027], [0031]; claims 1,2,5,10,14 *<br>----- | 1-8, 10-14 | INV.<br>C09J7/40 |
| X | WO 2009/069576 A1 (DENKI KAGAKU KOGYO KK [JP]; SUGINO JUNJI [JP] ET AL.) 4 June 2009 (2009-06-04)<br>* abstract *<br>* claims 1-4; figure 1; examples *<br>----- | 1-15 | |
| X | US 2010/209649 A1 (KUWAHARA RIE [JP] ET AL) 19 August 2010 (2010-08-19)<br>* abstract *<br>* paragraphs [0008], [0068] - paragraph [0076]; claims 1,2,10-16; example 1 *<br>----- | 1-15 | |

TECHNICAL FIELDS
SEARCHED (IPC)

C09J

## INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 26 June 2019 | Meier, Stefan |

EPO FORM 1503 03.82 (P04E07)

Europäisches
Patentamt

European
Patent Office

Office européen
des brevets

**INCOMPLETE SEARCH
SHEET C**

Application Number

EP 18 19 8699

Claim(s) completely searchable:
-

Claim(s) searched incompletely:
1-15

Reason for the limitation of the search:

Present claim 1 relates to a double-linered pressure-sensitive adhesive sheet which has a given desired property or effect, namely "the first and second release films have tensile elastic moduli E1 and E2 at an E2/E1 ratio value of 1.5 or greater". However, the description does not provide support and disclosure within the meaning of Art. 84 and 83 EPC for any such adhesive sheet having the said property or effect and there is no common general knowledge of this kind available to the person skilled in the art.

In addition, claim 1 of the present application encompasses a double-linered pressure-sensitive adhesive sheet defined only by its desired property concerning the first and second release films, contrary to the requirement of clarity in Art. 84 EPC, because the "result-to-be-achieved " type of definition does not allow the scope of the claim to be ascertained. The fact that any compound of the release liners could be screened does not overcome this objection, as the skilled person would not know beforehand whether it fell within the scope claimed, except for the release liners disclosed in claims 5 and 6 of the present application. Undue experimentation would be required to screen compositions for the release liners randomly.

In addition, amended independent claim 1 claims a double-linered pressure-sensitive adhesive sheet comprising a first and a second release film. However, said release films are defined in terms not of their chemical structure or composition, but solely of their desired properties (" "the first and second release films have tensile elastic moduli E 1 and E 2 at an E 2 /E 1 ratio value of 1.5 or greater "), which the skilled person can establish only by means of using a viscoelasticity measuring apparatus set out in the description.

This type of definition of the adhesive sheet by means of its parametric properties is directed not only to the compounds actually found according to the measurement method, but also to any composition for the release films not yet structurally defined on the priority or filing date of the application and can only be found by means of the method indicated in the description. Such a formulation of a claim thus constitutes a "reach-through" claim, i.e. a claim which is also directed to future inventions based on the one now being disclosed.

A definition of a double-linered pressure-sensitive adhesive sheet solely by the parametric properties of its release liners (in this case in a reach-through claim) covers all possible combinations of release films possessing the parameter ranges according to the claim. In the absence of any selection rule in the application in suit, the skilled person, without the possibility of having recourse to his common general knowledge, must resort to trial-and error experimentation on arbitrarily selected chemical compositions for the release films to establish whether these layers possess the parameters according to the claim; this represents for the skilled person an invitation to perform a research programme and thus an undue burden .

Europäisches
Patentamt

European
Patent Office

Office européen
des brevets

**INCOMPLETE SEARCH
SHEET C**

Application Number

EP 18 19 8699

Also for this reason, amended independent claim 1 does not fulfil the requirements of Art. 83 EPC.

In the reply to the Invitation pursuant to R. 63(1) EPC dated and received on 23.04.2019, the Applicant argued that there would be enough support and guidance in the description as originally filed which would enable the person skilled in the art to carry out the invention over the whole scope claimed. In particular, the Applicant drew the attention to paragraphs [0049] and [0050] of the description stating that the tensile moduli E1 and E2 could be adjusted through the material and production method of the first/second release film.

In contrast to the line of arguments brought forward by the Applicant, the Search Division is of the opinion that this statement even further fuels the objections brought forward in the invitation pursuant ti R. 63(1) EPC since there is no guidance which material or production method for the first/second release film had to be chosen, in order to arrive at the desired ratio of the tensile elastic moduli.

The Search Division agrees that this guidance can be found in the Examples of the description, however, in said Examples, two very specific materials for the first/second release films are employed, namely a PET, as member of the group of polyesters, and PE and OPP which belong to the group of polyolefins.

Consequently, the non-compliance with the substantive provisions is such that a meaningful search of the whole claimed subject-matter of the claim could/can not be carried out (R. 63 EPC).

Therefore, the restriction to a releasable polyolefin film as the first release film and a releasable polyester film as the second release film is fully justified and does not unduly limit the Applicant's technical contribution to the art.

Consequently, the search of the claims was restricted accordingly as suggested in the set of claims attached to the reply to the invitation pursuant to R. 63(1) EPC filed as an auxiliary indicative measure.

## ANNEX TO THE EUROPEAN SEARCH REPORT
## ON EUROPEAN PATENT APPLICATION NO.

EP 18 19 8699

This annex lists the patent family members relating to the patent documents cited in the above-mentioned European search report.
The members are as contained in the European Patent Office EDP file on
The European Patent Office is in no way liable for these particulars which are merely given for the purpose of information.

26-06-2019

| Patent document cited in search report | | Publication date | Patent family member(s) | | | Publication date |
|---|---|---|---|---|---|---|
| US 2013189468 | A1 | 25-07-2013 | NONE | | | |
| WO 2009069576 | A1 | 04-06-2009 | CN | 101874088 | A | 27-10-2010 |
| | | | JP | WO2009069661 | A1 | 14-04-2011 |
| | | | KR | 20100112117 | A | 18-10-2010 |
| | | | TW | 200932868 | A | 01-08-2009 |
| | | | WO | 2009069576 | A1 | 04-06-2009 |
| | | | WO | 2009069661 | A1 | 04-06-2009 |
| US 2010209649 | A1 | 19-08-2010 | CN | 101805573 | A | 18-08-2010 |
| | | | JP | 5243990 | B2 | 24-07-2013 |
| | | | JP | 2010192636 | A | 02-09-2010 |
| | | | US | 2010209649 | A1 | 19-08-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2017196425 A
- JP 2017132911 A
- JP 2013100485 A
- JP 2017002292 A
- JP 2015147873 A
- JP 2007051271 A

### Non-patent literature cited in the description

- **C. A. DAHLQUIST.** Adhesion: Fundamental and Practice. McLaren & Sons, 1966, 143
- Polymer Handbook. John Wiley & Sons, Inc, 1989